(19) Europäisches Patentamt
European Patent Office
Office européen des brevets

(11) **EP 3 462 651 B1**

## (12) EUROPEAN PATENT SPECIFICATION

(45) Date of publication and mention
of the grant of the patent:
**29.07.2020 Bulletin 2020/31**

(21) Application number: **17818921.3**

(22) Date of filing: **26.04.2017**

(51) Int Cl.:
*H04L 1/00* (2006.01)   *H03M 13/00* (2006.01)

(86) International application number:
**PCT/CN2017/082064**

(87) International publication number:
**WO 2018/000924 (04.01.2018 Gazette 2018/01)**

(54) **FRAME TRANSMISSION METHOD AND APPARATUS**

VERFAHREN UND VORRICHTUNG ZUR RAHMENÜBERTRAGUNG

PROCÉDÉ ET APPAREIL DE TRANSMISSION DE TRAMES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.06.2016 CN 201610495415**

(43) Date of publication of application:
**03.04.2019 Bulletin 2019/14**

(73) Proprietor: **Huawei Technologies Co., Ltd.
Longgang District
Shenzhen, Guangdong 518129 (CN)**

(72) Inventor: **WU, Tao
Shenzhen
Guangdong 518129 (CN)**

(74) Representative: **Thun, Clemens
Mitscherlich PartmbB
Patent- und Rechtsanwälte
Sonnenstraße 33
80331 München (DE)**

(56) References cited:
**EP-A2- 2 320 574      CN-A- 101 626 360
CN-A- 103 780 554      CN-A- 104 618 067
CN-A- 104 618 072      US-A1- 2016 164 800**

- **ALECSANDER EITAN (QUALCOMM): "PHY
  Frame Format proposal for 11ay ;
  11-16-0061-00-00ay-phy-frame-format-propos
  al-for-11ay", IEEE DRAFT;
  11-16-0061-00-00AY-PHY-FRAME-FORMAT-PRO
  POS AL-FOR-11AY, IEEE-SA MENTOR,
  PISCATAWAY, NJ USA, vol. 802.11ay, 18 January
  2016 (2016-01-18), pages 1-9, XP068104825,
  [retrieved on 2016-01-18]**
- **ZHU, QI et al.: "Performance Analysis of LDPC
  Codes for IEEE 802.16a OFDM System in
  Multipath Fading Channel", ACTA
  ELECTRONICA SINICA, vol. 33, no. 4, 30 April
  2005 (2005-04-30) , pages 624-628, XP009511545,**

EP 3 462 651 B1

## Description

### TECHNICAL FIELD

This application relates to the communications field, and more specifically, to a frame transmission method and apparatus.

### BACKGROUND

Standardization of a wireless local area network (Wireless Local Area Network, WLAN) based on 802.11 family standards greatly reduces costs of WLAN technologies. Wireless Fidelity (Wireless Fidelity, Wi-Fi) is a brand of a wireless network communications technology and held by the Wi-Fi Alliance. An objective of Wi-Fi is to improve interoperability between wireless network products based on the 802.11 standards. A wireless local area network using 802.11 family protocols may be referred to as a Wi-Fi network.

Currently, the 802.11 standards are technically more mature after developing into various versions such as 802.11a, 802.11b, 802.11g, 802.11n, and 802.11ac. 802.11ad is a branch in an Institute of Electrical and Electronics Engineers (Institute of Electrical and Electronics Engineers, IEEE) 802.11 (or referred to as WLAN, wireless local area network) system, and operates on a high frequency band of 60 GHz. Single-carrier modulation is an implementation method of 802.11ad technologies. In 802.11ad, a 64-bit Header sequence may be transmitted based on a single-carrier header (Header) design.

Currently, an enhanced directional multi-gigabit header (enhanced directional multi-gigabit Header, EDMG Header) field is added in a frame structure determined in standard discussion of 802.11ay in comparison of 802.11ad, to indicate control signaling in 802.11ay. In order to use a design in 802.11ad, in an existing EDMG Header design solution, after a bit is filled in an EDMG Header sequence, the EDMG Header sequence is divided into a plurality of 64-bit sequences for frame transmission based on a Header design in 802.11ad. However, in this method, encoding, modulation, and transmission are performed in a unit of 64 bits, transmission performance is limited, and particularly, a transmission performance requirement cannot be met in a long distance transmission condition.

US 2016/0164800 A1 discloses a frame format for 802.11 very high throughput such as 802.11ay supporting channel bonding and MIMO. The frame format includes an enhanced directional multi-gigabit (EDMG) header including additional header and preamble information.

EP 2320574 A2 discloses scrambling, padding and LDPC-encoding of information bits for a frame header in a SC or OFDM signalling system. The encoded bits are repeated for transmission.

### SUMMARY

This application provides a frame transmission method and apparatus, to improve frame transmission performance.

According to a first aspect, a frame transmission method is provided, and the method includes: obtaining an initial enhanced directional multi-gigabit header (EDMG Header) sequence, where the initial EDMG Header sequence includes N control bits, and N is a positive integer; performing a padding operation on the initial EDMG Header sequence to obtain a padded sequence, where the padded sequence includes N information bits and L padding bits, and the N information bits are the N control bits, or the N information bits are obtained by scrambling the N control bits; performing 1/2 low-density parity-check (Low Density Parity Check, LDPC) encoding on the padded sequence to obtain an encoded sequence, where the encoded sequence includes the N information bits, the L padding bits, and N+L parity check bits generated through encoding, and L is a positive integer; constituting a first sequence by using the N information bits and all the parity check bits in the encoded sequence, and obtaining a second sequence based on the first sequence, where a length of the first sequence is the same as a length of the second sequence; modulating the first sequence to obtain a first modulated sequence, and modulating the second sequence to obtain a second modulated sequence; and inserting a guard interval GI between the first modulated sequence and the second modulated sequence, obtaining an encoded and modulated EDMG Header sequence based on a sequence obtained after the guard interval is inserted, combining the encoded and modulated EDMG Header sequence and to-be-sent data to obtain a frame, and transmitting the frame.

In this application, uniform 1/2 LDPC encoding is performed after the padding operation is performed on the control bits in the EDMG Header sequence, and two sequences that each include all the control bits are directly obtained based on the encoded sequence obtained after encoding. Then, modulation is performed on the two sequences to obtain the frame, and the frame is transmitted. Such a retransmission design can improve frame transmission performance.

In an embodiment of the present invention, padding may be directly performed on the bits in the EDMG Header sequence. Correspondingly, the padded sequence includes the N information bits and the L padding bits, and the N information bits may be the N control bits in the initial EDMG Header sequence. In another embodiment of the present invention, before the padding operation is performed on the initial EDMG Header sequence, scrambling processing may be first performed on the initial EDMG Header sequence, and then the padding operation is performed on a sequence obtained after scrambling processing. Correspondingly, the padded sequence includes the N information bits and the L padding bits, and the N information bits may be obtained by scrambling the N control bits.

In an embodiment of the present invention, the N control bits included in the initial EDMG Header sequence may include some cyclic redundancy check (Cyclic Redundancy Check, CRC) bits, and a quantity of the CRC bits may be 16, 32, or the like.

In this application, frame retransmission may be implemented by constructing two sequences that each include the N information bits. Such a design can meet a requirement of long distance frame transmission, and improve transmission performance.

With reference to the first aspect, in an implementation of the first aspect, a length of the encoded sequence is 672, both the length of the first sequence and the length of the second sequence are 448, and N+L=336.

In an embodiment of the present invention, the length of the encoded sequence may be 672, in other words, the encoded sequence includes 672 bits. The first sequence and the second sequence have a same length that is 448. To be specific, in an embodiment of the present invention, two sequences that each include 448 bits may be directly constructed from the encoded sequence, and a guard interval is inserted between the two sequences. There is no need to construct two 224-bit sequences from the encoded sequence and combine the two 224-bit sequences into a 448-bit sequence. In this way, uniform encoding can improve frame transmission performance.

In an embodiment of the present invention, uniform encoding is performed on the information bits, and two 448-bit sequences are directly constructed from the encoded sequence obtained after encoding, to implement signaling retransmission. There is no need to divide the sequence obtained after encoding into a plurality of 64-bit sequences and process each 64-bit sequence by using a method in 802.11ad. In this way, signaling retransmission can be implemented, frame transmission performance can be improved, and transmission accuracy can be improved.

With reference to the first aspect and the foregoing implementation of the first aspect, in another implementation of the first aspect, when N=112, the obtaining a second sequence based on the first sequence includes: performing an exclusive OR operation on the first sequence to obtain the second sequence; or performing interleaving processing on the first sequence to obtain the second sequence.

For example, when N=112, it is assumed that the initial EDMG Header sequence is $b_1, b_2, ..., b_{112}$, and a sequence obtained after scrambling processing is performed on the sequence $b_1, b_2,..., b_{112}$ is $q_1, q_2,..., q_{112}$. The padded sequence is $q_1, q_2,..., q_{112}, 0_1, 0_2, ..., 0_{224}$, and the encoded sequence is $q_1, q_2, ..., q_{112}, 0_1, 0_2,..., 0_{224}, p_1, p_2, ..., p_{336}$. $p_1, p_2,..., p_{336}$ is a parity check bit sequence generated through 1/2 LDPC encoding. The first sequence constructed from the foregoing encoded sequence may be $q_1, q_2, ..., q_{112}, p_1, p_2, ..., p_{336}$, and the second sequence may be obtained after the exclusive OR operation or interleaving processing is performed on the first sequence.

In an embodiment of the present invention, if a length of the initial EDMG Header sequence that needs to be transmitted is less than 112, the padding operation may be performed on the initial EDMG Header sequence, so that the length of the initial EDMG Header sequence reaches 112, and the frame transmission method used when N=112 is used.

With reference to the first aspect and the foregoing implementations of the first aspect, in another implementation of the first aspect, the performing an exclusive OR operation on the first sequence to obtain the second sequence includes: performing the exclusive OR operation on the first sequence by using a pseudo-random sequence to obtain the second sequence; or performing the exclusive OR operation on the first sequence by using a sequence {0, 1, 0, 1, ..., 0, 1} or a sequence {1, 0, 1, ..., 1, 0} to obtain the second sequence.

With reference to the first aspect and the foregoing implementations of the first aspect, in another implementation of the first aspect, the modulating the first sequence to obtain a first modulated sequence and modulating the second sequence to obtain a second modulated sequence includes: performing $\pi/2$ BPSK modulation or BPSK modulation on the first sequence to obtain the first modulated sequence; and performing $\pi/2$ BPSK modulation or BPSK modulation on the second sequence to obtain the second modulated sequence.

According to a second aspect, a frame transmission method is provided, and the method includes: obtaining an initial enhanced directional multi-gigabit header EDMG Header sequence, where the initial EDMG Header sequence includes N control bits, and N is a positive integer; performing a padding operation on the initial EDMG Header sequence to obtain a padded sequence, where the padded sequence includes N information bits and L padding bits, and the N information bits are the N control bits, or the N information bits are obtained by scrambling the N control bits; performing 1/2 low-density parity-check LDPC encoding on the padded sequence to obtain an encoded sequence, where the encoded sequence includes the N information bits, the L padding bits, and N+L parity check bits generated through encoding, and L is a positive integer; constituting a first sequence by using the N information bits and a first part of the parity check bits in the encoded sequence, and obtaining a second sequence based on the N information bits and a second part of the parity check bits in the encoded sequence, where a length of the first sequence is the same as a length of the second sequence, and bits included in the first part of the parity check bits are not completely the same as those included in the second part of the parity check bits; modulating the first sequence to obtain a first modulated sequence, and modulated the second sequence to obtain a second modulated sequence; and inserting a guard interval GI between the first modulated sequence and the second modulated sequence, obtaining an encoded and modulated EDMG Header sequence based on a sequence obtained after the guard interval is inserted, combining the encoded and modulated EDMG Header sequence and to-be-sent data to obtain a frame, and transmitting the frame.

With reference to the second aspect, in an implementation of the second aspect, a length of the encoded sequence is 672, both the length of the first sequence and the length of the second sequence are 448, and N+L=336.

With reference to the second aspect and the foregoing implementation of the second aspect, in another implementation of the second aspect, when N>112, the obtaining the second sequence based on the N information bits and a second part of the parity check bits in the encoded sequence includes: constituting the second sequence by using the N information bits and the second part of the parity check bits in the encoded sequence.

In an embodiment of the present invention, if N>112, a total quantity of the N information bits and the N+L parity check bits is greater than 448. In this case, a length of a sequence directly constructed from the information bits and the parity check bits in the encoded sequence is greater than 448. Therefore, some bits need to be discarded, so that a length of a constructed sequence is 448. To be specific, when N>112, the N information bits and the first part of the parity check bits may constitute the first sequence of 448 bits, and the second sequence of 448 bits may be constructed based on the N information bits and the second part of the parity check bits, so that the first sequence and the second sequence each include the N information bits. The information bits are retransmitted. Therefore, frame transmission accuracy can be improved, and transmission performance can be improved.

If N>112, it is assumed that the initial EDMG Header sequence is $b_1, b_2, ..., b_N$, and a sequence obtained after scrambling processing is performed on the sequence $b_1, b_2, ..., b_N$ is $q_1, q_2, ..., q_N$. The padded sequence is $q_1, q_2, ..., q_N, 0_1, 0_2, ..., 0_{336-N}$, and the encoded sequence is $q_1, q_2, ..., q_N, 0_1, 0_2, ..., 0_{336-N}, p_1, p_2, ..., p_{336}$. $p_1, p_2, ..., p_{336}$ is a parity check bit sequence generated through 1/2 LDPC encoding. The first sequence constructed from the foregoing encoded sequence may be $q_1, q_2..., q_N, p_1, p_2, ..., p_{448-N}$, a third sequence constructed from the foregoing encoded sequence may be $q_1, q_2, ..., q_N, p_1, p_2, ..., p_{560-2N}, p_{448-N+1}, ..., p_{336}$, and the second sequence may be obtained after an exclusive OR operation or interleaving processing is performed on the third sequence.

Particularly, when N=128, the first sequence may be $q_1, q_2, ..., q_{128}, p_1, p_2, ..., p_{320}$, and the third sequence may be $q_1, q_2, ..., q_{128}, p_1, p_2, ..., p_{304}, p_{321}, ..., p_{336}$.

With reference to the second aspect and the foregoing implementations of the second aspect, in another implementation of the second aspect, when N>112, the obtaining the second sequence based on the N information bits and a second part of the parity check bits in the encoded sequence includes: constituting a third sequence by using the N information bits and the second part of the parity check bits in the encoded sequence; and performing an exclusive OR operation or interleaving processing on the third sequence to obtain the second sequence.

With reference to the second aspect and the foregoing implementations of the second aspect, in another implementation of the second aspect, the performing an exclusive OR operation or interleaving processing on the third sequence to obtain the second sequence includes: performing the exclusive OR operation on the third sequence by using a pseudo-random sequence to obtain the second sequence; or performing the exclusive OR operation on the third sequence by using a sequence {0, 1, 0, 1, ..., 0, 1} or a sequence {1, 0, 1, ..., 1, 0} to obtain the second sequence.

With reference to the second aspect and the foregoing implementations of the second aspect, in another implementation of the second aspect, the first part of the parity check bits and the second part of the parity check bits constitute all the parity check bits.

In an embodiment of the present invention, the first part of the parity check bits constitutes a first set, the second part of the parity check bits constitutes a second set, and a union set of the first set and the second set constitutes all the parity check bits. In this way, the parity check bits are fully used when the first sequence and the second sequence are constructed, so that frame transmission performance can be improved.

With reference to the second aspect and the foregoing implementations of the second aspect, in another implementation of the second aspect, a quantity of common bits between the first part of the parity check bits and the second part of the parity check bits is greater than a threshold, and the threshold is a preset value, or the threshold is determined by a quantity of all the parity check bits.

In an embodiment of the present invention, the first part of the parity check bits constitutes the first set, and the second part of the parity check bits constitutes the second set, an intersection set of the first set and the second set constitutes a third set. A quantity of bits in the third set is closer to a total quantity of parity check bits, fewer parity check bits are discarded when the sequence is constructed, and the frame transmission performance may be better.

In an embodiment of the present invention, a guard interval is inserted between the first modulated sequence and the second modulated sequence, a guard interval is inserted before the first modulated sequence, and a guard interval is inserted after the second modulated sequence, to obtain the encoded and modulated EDMG Header. The encoded and modulated EDMG Header and the to-be-sent data are combined to obtain the frame, and the frame is transmitted.

With reference to the second aspect and the foregoing implementations of the second aspect, in another implementation of the second aspect, the modulating the first sequence to obtain a first modulated sequence and modulating the second sequence to obtain a second modulated sequence includes: performing $\pi/2$ BPSK modulation or BPSK modulation on the first sequence to obtain the first modulated sequence; and performing $\pi/2$ BPSK modulation or BPSK modulation on the second sequence to obtain the second modulated sequence.

In other words, a modulation manner of the first sequence and the second sequence in this application may be BPSK modulation or $\pi/2$ BPSK modulation.

According to a third aspect, a frame transmission apparatus is provided, and the apparatus includes: an obtaining unit, configured to obtain an initial enhanced directional multi-gigabit header (enhanced directional multi-gigabit header, EDMG Header) sequence, where the initial EDMG Header sequence includes N control bits, and N is a positive integer; a padding unit, configured to perform a padding operation on the initial EDMG Header sequence obtained by the obtaining unit to obtain a padded sequence, where the padded sequence includes N information bits and L padding bits, and the N information bits are the N control bits, or the N information bits are obtained by scrambling the N control bits; an encoding unit, configured to perform 1/2 low-density parity-check LDPC encoding on the padded sequence obtained by the padding unit, to obtain an encoded sequence, where the encoded sequence includes the N information bits, the L padding bits, and N+L parity check bits generated through encoding, and L is a positive integer; a constructing unit, configured to: constitute a first sequence by using the N information bits and all the parity check bits in the encoded sequence obtained by the encoding unit, and obtain a second sequence based on the first sequence, where a length of the first sequence is the same as a length of the second sequence; a modulation unit, configured to separately perform modulation on the first sequence and the second sequence that are obtained by the constructing unit, to obtain a first modulated sequence and a second modulated sequence; and a processing and transmission unit, configured to: insert a guard interval GI between the first modulated sequence and the second modulated sequence that are obtained by the modulation unit, obtain an encoded and modulated EDMG Header sequence based on a sequence obtained after the guard interval is inserted, combine the encoded and modulated EDMG Header sequence and to-be-sent data to obtain a frame, and transmit the frame.

In this application, uniform 1/2 LDPC encoding is performed after the padding operation is performed on the control bits in the EDMG Header sequence, and two sequences that each include all the control bits are directly obtained based on the encoded sequence obtained after encoding. Then, modulation is performed on the two sequences to obtain the frame, and the frame is transmitted. Such a retransmission design can improve frame transmission performance.

With reference to the third aspect, in an implementation of the third aspect, a length of the encoded sequence is 672, both the length of the first sequence and the length of the second sequence are 448, and N+L=336.

With reference to the third aspect and the foregoing implementation of the third aspect, in another implementation of the third aspect, when N=112, the constructing unit is specifically configured to: perform an exclusive OR operation on the first sequence to obtain the second sequence; or perform interleaving processing on the first sequence to obtain the second sequence.

With reference to the third aspect and the foregoing implementations of the third aspect, in another implementation of the third aspect, the constructing unit is specifically configured to: perform the exclusive OR operation on the first sequence by using a pseudo-random sequence to obtain the second sequence; or perform the exclusive OR operation on the first sequence by using a sequence {0, 1, 0, 1, ..., 0, 1} or a sequence {1, 0, 1, ..., 1, 0} to obtain the second sequence.

With reference to the third aspect and the foregoing implementations of the third aspect, in another implementation of the third aspect, the modulation unit is specifically configured to: perform $\pi/2$ BPSK modulation or BPSK modulation on the first sequence to obtain the first modulated sequence; and perform $\pi/2$ BPSK modulation or BPSK modulation on the second sequence to obtain the second modulated sequence.

For the frame transmission apparatus according to the third aspect of this application, refer to the procedure of the frame transmission method in the first aspect of this application, and the units/modules in the apparatus and other operations and/or functions are respectively intended to implement the corresponding procedure in the method shown in the first aspect. For brevity, details are not described herein.

According to a fourth aspect, a frame transmission apparatus is provided, and the apparatus includes: an obtaining unit, configured to obtain an initial enhanced directional multi-gigabit header (enhanced directional multi-gigabit header, EDMG Header) sequence, where the initial EDMG Header sequence includes N control bits, and N is a positive integer; a padding unit, configured to perform a padding operation on the initial EDMG Header sequence obtained by the obtaining unit, to obtain a padded sequence, where the padded sequence includes N information bits and L padding bits, and the N information bits are the N control bits, or the N information bits are obtained by scrambling the N control bits; an encoding unit, configured to perform 1/2 low-density parity-check LDPC encoding on the padded sequence obtained by the padding unit, to obtain an encoded sequence, where the encoded sequence includes the N information bits, the L padding bits, and N+L parity check bits generated through encoding, and L is a positive integer; a constructing unit, configured to: constitute a first sequence by using the N information bits and a first part of the parity check bits in the encoded sequence obtained by the encoding unit, and obtain a second sequence based on the N information bits and a second part of the parity check bits in the encoded sequence obtained by the encoding unit, where a length of the first sequence is the same as a length of the second sequence, and bits included in the first part of the parity check bits are not completely the same as those included in the second part of the parity check bits; a modulation unit, configured to separately perform modulation on the first sequence and the second sequence that are obtained by the constructing unit, to obtain a first modulated sequence and a second modulated sequence; and a processing and transmission unit, configured to: insert a guard interval GI between the first modulated sequence and the second modulated sequence that are obtained by the modulation unit, obtain an encoded and modulated EDMG Header sequence based on a sequence obtained after the guard interval is inserted, combine the encoded and modulated EDMG Header sequence and to-be-sent data to obtain a frame, and transmit the frame.

With reference to the fourth aspect, in an implementation of the fourth aspect, a length of the encoded sequence is 672, both the length of the first sequence and the length of the second sequence are 448, and N+L=336.

With reference to the fourth aspect and the foregoing implementation of the fourth aspect, in another implementation of the fourth aspect, when N>112, the constructing unit is specifically configured to constitute the second sequence by using the N information bits and the second part of the parity check bits in the encoded sequence.

With reference to the fourth aspect and the foregoing implementations of the fourth aspect, in another implementation of the fourth aspect, when N>112, the constructing unit is specifically configured to: constitute a third sequence by using the N information bits and the second part of the parity check bits in the encoded sequence; and perform an exclusive OR operation or interleaving processing on the third sequence to obtain the second sequence.

With reference to the fourth aspect and the foregoing implementations of the fourth aspect, in another implementation of the fourth aspect, the constructing unit is specifically configured to: perform the exclusive OR operation on the third sequence by using a pseudo-random sequence to obtain the second sequence; or perform the exclusive OR operation on the third sequence by using a sequence {0, 1, 0, 1, ..., 0, 1} or a sequence {1, 0, 1, ..., 1, 0} to obtain the second sequence.

With reference to the fourth aspect and the foregoing implementations of the fourth aspect, in another implementation of the fourth aspect, the first part of the parity check bits and the second part of the parity check bits constitute all the parity check bits.

With reference to the fourth aspect and the foregoing implementations of the fourth aspect, in another implementation of the fourth aspect, a quantity of common bits between the first part of the parity check bits and the second part of the parity check bits is greater than a threshold, and the threshold is a preset value, or the threshold is determined by a quantity of all the parity check bits.

In an embodiment of the present invention, the processing and transmission unit is specifically configured to: insert a guard interval between the first modulated sequence and the second modulated sequence, insert a guard interval before the first modulated sequence, and insert a guard interval after the second modulated sequence, to obtain the encoded and modulated EDMG Header sequence. The encoded and modulated EDMG Header sequence and the to-be-sent data are combined to obtain the frame, and the frame is transmitted.

With reference to the fourth aspect and the foregoing implementations of the fourth aspect, in another implementation of the fourth aspect, the modulation unit is specifically configured to: perform $\pi/2$ BPSK modulation or BPSK modulation on the first sequence to obtain the first modulated sequence; and perform $\pi/2$ BPSK modulation or BPSK modulation on the second sequence to obtain the second modulated sequence.

For the frame transmission apparatus according to the fourth aspect of this application, refer to the procedure of the frame transmission method in the second aspect of this application, and the units/modules in the apparatus and other operations and/or functions are respectively intended to implement the corresponding procedure in the method shown in the second aspect. For brevity, details are not described herein.

According to a fifth aspect, a frame transmission method is provided, and the method includes: receiving the frame according to the first aspect, and demodulating and decoding the frame.

For a composition manner of the frame in the frame transmission method according to this application, refer to a composition manner of the frame in the first aspect. To avoid repetition, details are not described herein again.

According to a sixth aspect, a frame transmission method is provided, and the method includes: receiving the frame according to the second aspect, and demodulating and decoding the frame.

For a composition manner of the frame in the frame transmission method according to this application, refer to a composition manner of the frame in the second aspect. To avoid repetition, details are not described herein again.

## BRIEF DESCRIPTION OF DRAWINGS

FIG. 1 is a schematic diagram of a scenario of a communications system that may be applied to this application;

FIG. 2 is a schematic flowchart of a frame transmission method according to an embodiment of the present invention;

FIG. 3 is a schematic flowchart of a frame transmission method according to another embodiment of the present invention;

FIG. 4 is a schematic structural diagram of a frame in the 802.11ay protocol according to an embodiment of the present invention;

FIG. 5 is a schematic diagram of an EDMG Header field in a structure of a frame in the 802.11ay protocol according to an embodiment of the present invention;

FIG. 6 is a schematic flowchart of a frame transmission method according to another embodiment of the present invention;

FIG. 7 is a schematic flowchart of a frame transmission method according to another embodiment of the present invention;

FIG. 8 is a schematic structural diagram of a frame transmission apparatus according to an embodiment of the present invention;

FIG. 9 is a schematic structural diagram of a frame transmission apparatus according to another embodiment of the present invention;

FIG. 10 is a schematic structural diagram of a frame transmission apparatus according to another embodiment of the present invention; and

FIG. 11 is a schematic structural diagram of a frame transmission apparatus according to another embodiment of the present invention.

## DESCRIPTION OF EMBODIMENTS

The following clearly and completely describes the technical solutions in this application with reference to the accompanying drawings in this application.

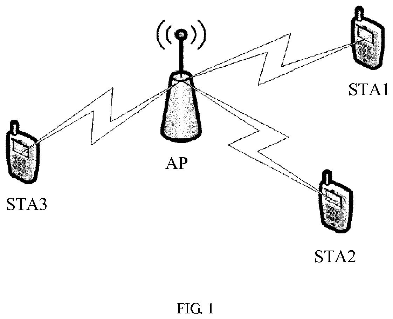

FIG. 1 is a schematic diagram of a scenario of a communications system that may be applied to this application. The communications system in FIG. 1 includes one AP and three STAs, for example, a STA1, a STA2, and a STA3 in FIG. 1. The AP may communicate with the STA1, the STA2, and the STA3. In this system, the AP may schedule a plurality of STAs to perform signaling transmission and demodulation. It should be noted that a quantity of STAs is not limited, and three STAs are merely used as an example for description in the present invention.

The technical solutions in the present invention may be applied to various communications systems in which a frame needs to be transmitted, for example, applied to a WLAN, Wi-Fi, and the like of a multi-user multiple-input multiple-output (Multi-User multiple-input multiple-output, MU-MIMO) technology.

The access point (Access Point, AP) is also referred to as a wireless access point, a hotspot, or the like. The AP is an access point used by a mobile user to access a wired network. The AP is mainly deployed in a house, inside a building, and inside a park. A typical coverage radius is tens of meters to hundreds of meters. Certainly, the AP may also be deployed outdoors. The AP is equivalent to a bridge that connects a wired network and a wireless network. A major function of the AP is to connect various wireless network clients and connect the wireless network to the Ethernet. Currently, standards mainly used by the AP are the Institute of Electrical and Electronics Engineers (Institute of Electrical and Electronics Engineers, IEEE) 802.11 family. Specifically, the AP may be a terminal device or network device that has a Wi-Fi chip. Optionally, the AP may be a device that supports the 802.11ay standard. Further, optionally, the AP may be a device that supports a plurality of WLAN standards such as 802.11ay, 802.11ad, 802.11ac, 802.11n, 802.11g, 802.11b, and 802.11a.

The station (Station, STA) may be a wireless communications chip, a wireless sensor, or a wireless communications terminal, for example, a mobile phone that supports a Wi-Fi communication function, a tablet computer that supports a Wi-Fi communication function, a set top box that supports a Wi-Fi communication function, and a computer that supports a Wi-Fi communication function. Optionally, the station may support the 802.11ay standard. Further, optionally, the station supports a plurality of WLAN standards such as 802.11ay, 802.11ad, 802.11ac, 802.11n, 802.11g, 802.11b, and 802.11a.

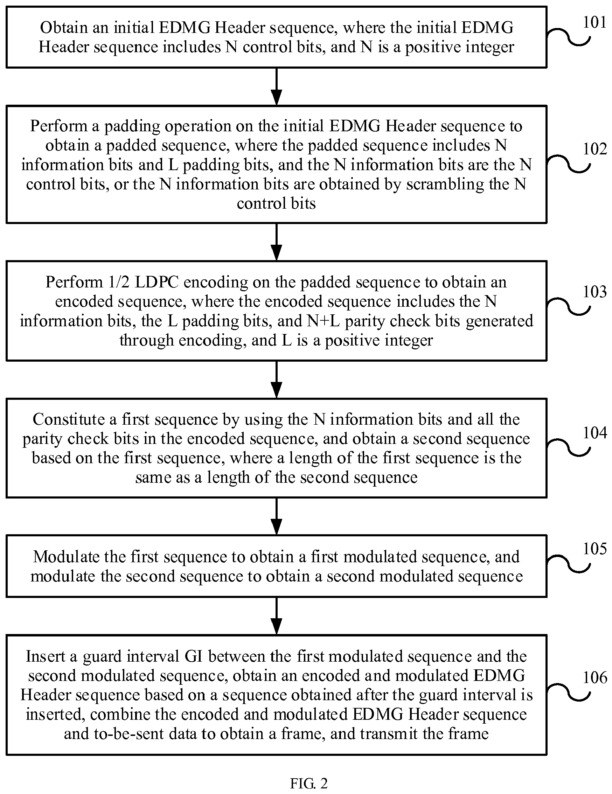

FIG. 2 is a schematic flowchart of a frame transmission method according to an embodiment of the present invention. The method shown in FIG. 2 may be performed by the AP in FIG. 1, or may be performed by a STA in FIG. 1. Devices that perform the method in FIG. 2 may be collectively referred to as a transmitter. A specific procedure of the frame transmission method shown in FIG. 2 is as follows.

101. Obtain an initial enhanced directional multi-gigabit header EDMG Header sequence. The initial EDMG Header sequence includes N control bits, and N is a positive integer.

The N control bits in the initial EDMG Header sequence may include CRC bits. An order of CRC check and scrambling processing that are performed on a bit sequence that needs to be transmitted may be interchanged, and the initial EDMG Header sequence may be obtained after scrambling and/or CRC check. In this application, scrambling processing may not be performed on the bit sequence that needs to be transmitted, and a sequence obtained after CRC check is used as the initial EDMG Header sequence.

102. Perform a padding operation on the initial EDMG Header sequence to obtain a padded sequence. The padded sequence includes N information bits and L padding bits, and the N information bits are the N control bits, or the N information bits are obtained by scrambling the N control bits.

In this application, when the padding operation is performed on the initial EDMG Header sequence, 0 bits may be filled on the basis of the initial EDMG Header sequence, in other words, value of the padded bits in this application may be 0. The padding operation is to meet a requirement of a quantity of bits in subsequent LDPC encoding. For example, when 1/2 LDPC encoding needs to be performed, and a sequence obtained after encoding needs to meet 672 bits, a quantity of bits in a bit sequence before encoding needs to meet 1/2 of 672, namely, 336, and a quantity of parity check bits generated through 1/2 LDPC encoding is also 1/2 of 672, namely, 336.

103. Perform 1/2 low-density parity-check LDPC encoding on the padded sequence to obtain an encoded sequence. The encoded sequence includes the N control bits, the L padding bits, and N+L parity check bits generated through encoding, and L is a positive integer.

If it is necessary to meet a condition that the sequence obtained after encoding needs to be 672 bits, N+L=336 needs to be met.

104. Constitute a first sequence by using N information bits and all parity check bits in the encoded sequence, and obtain a second sequence based on the first sequence, where a length of the first sequence is the same as a length of the second sequence.

If N=112, it is assumed that the EDMG Header sequence, that needs to be transmitted is $b_1$, $b_2$, ..., $b_{112}$, and a sequence obtained after scrambling processing is performed on the sequence $b_1$, $b_2$,..., $b_{112}$ is $q_1$, $q_2$,..., $q_{112}$. The padded sequence is $q_1$, $q_2$,..., $q_{112}$, $0_1$, $0_2$, ..., $0_{224}$, and the encoded sequence is $q_1$, $q_2$, ..., $q_{112}$, $0_1$, $0_2$, ..., $0_{224}$, $p_1$, $p_2$, ..., $p_{336}$. $p_1$, $p_2$, ..., $p_{336}$ is a parity check bit sequence generated through 1/2 LDPC encoding. The first sequence constructed from the foregoing encoded sequence may be $q_1$, $q_2$, ..., $q_{112}$, $p_1$, $p_2$..., $p_{336}$, and the second sequence may be obtained after an exclusive OR operation or interleaving processing is performed on the first sequence.

In addition, in this application, the first sequence may be directly used as the second sequence, and the exclusive OR operation or interleaving processing is not performed.

In an embodiment of the present invention, both the length of the first sequence and the length of the second sequence are 448.

In this application, the exclusive OR operation may be performed by using a sequence {0, 1, 0, 1, ..., 0, 1} or a sequence {1, 0, 1, ..., 1, 0}, or may be performed by using a pseudo-random sequence. This is not limited in this application.

105. Modulate the first sequence to obtain a first modulated sequence, and modulate the second sequence to obtain a second modulated sequence.

In an embodiment of the present invention, binary phase shift keying (Binary Phase Shift Keying, BPSK) modulation or π/2 BPSK modulation may be used to modulate the first sequence and the second sequence, to obtain the corresponding first modulated sequence and second modulated sequence.

106. Insert a guard interval GI between the first modulated sequence and the second modulated sequence, obtain an encoded and modulated EDMG Header sequence based on a sequence obtained after the guard interval is inserted, combine the encoded and modulated EDMG Header sequence and to-be-sent data to constitute a frame, and transmit the frame.

The guard interval is inserted between the first modulated sequence and the second modulated sequence, and this may be distinguished from a Header design in 802.1 1ad. In the 802.11ad design, two 224-bit sequences are constructed, the two 224-bit sequences are directly combined to constitute one 448-bit sequence, and no guard interval is inserted between the two 224-bit sequences. Then, reverse ordering is performed on the 448-bit sequence to constitute another 448-bit sequence, and a guard interval is inserted between the two 448-bit sequences, to obtain an encoded and modulated EDMG Header sequence. The encoded and modulated EDMG Header sequence and to-be-sent data are combined to constitute a frame, and the frame is transmitted. However, in this application, 448 bits sequence are directly constructed, and an implementation is easier.

In addition, in an embodiment of the present invention, a guard interval may be further inserted before the first modulated sequence and a guard interval may be further inserted after the second modulated sequence. During transmission of a frame obtained in such a manner, frame transmission reliability can be improved.

In this application, uniform 1/2 LDPC encoding is performed after the padding operation is performed on the control bits in the EDMG Header sequence, and two sequences that each include all the control bits are directly obtained based on the encoded sequence obtained after encoding. Then, modulation is performed on the two sequences to obtain the frame, and the frame is transmitted. Such a retransmission design can improve frame transmission performance.

In an embodiment of the present invention, the method in FIG. 2 may be performed by a transmitter in a single carrier system. After receiving the frame, a receiver may divide the received frame into blocks, delete a cyclic prefix in each block, and perform Fourier transform on a data group obtained after the cyclic prefix is deleted, to transform the data group to frequency domain. Then, frequency domain equalization processing is performed, by using frequency domain channel information, on the data transformed to frequency domain, and inverse Fourier transform is performed on data obtained after frequency domain equalization, to transform the data back to time domain, so as to perform demodulation and decoding processing on a time-domain signal.

Specifically, when performing demodulation and decoding on the frame, the receiver may separately perform demodulation on the two received sequences whose lengths are 448 to obtain two corresponding log-likelihood ratios; combine the two log-likelihood ratios to obtain one or more sequences; combine the one or more sequences, and insert a bit 0 between the sequences, so that a length of a combined sequence is 672; perform LDPC decoding on the sequence whose length is 672 to obtain 336 bit valuations; and determine, from the 336 bit valuations, valuations of the N control bits in the EDMG Header sequence sent by the transmitter.

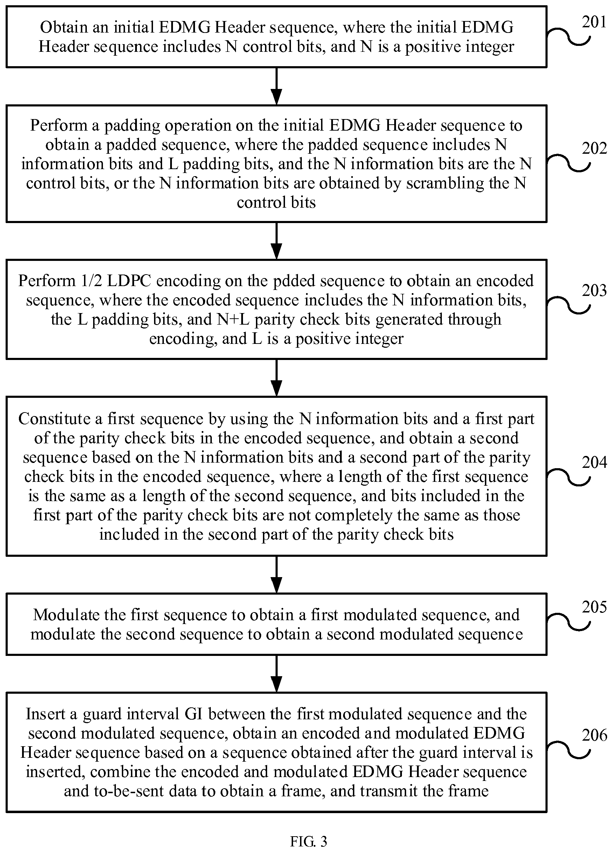

FIG. 3 is a schematic flowchart of a frame transmission method according to another embodiment of the present invention. The method shown in FIG. 3 may be performed by the AP in FIG. 1, or may be performed by a STA in FIG. 1. Devices that perform the method in FIG. 3 may be collectively referred to as a transmitter. A specific procedure of the frame transmission method shown in FIG. 3 is as follows.

201. Obtain an initial enhanced directional multi-gigabit header EDMG Header sequence. The initial EDMG Header sequence includes N control bits, and N is a positive integer.

The N control bits in the initial EDMG Header sequence may include CRC bits. An order of CRC check and scrambling processing that are performed on a bit sequence that needs to be transmitted may be interchanged, and the initial EDMG Header sequence may be obtained after scrambling and/or CRC check. In this application, scrambling processing may not be performed on the bit sequence that needs to be transmitted, and a sequence obtained after CRC check is used as the initial EDMG Header sequence.

202. Perform a padding operation on the initial EDMG Header sequence to obtain a padded sequence. The padded sequence includes N information bits and L padding bits, and the N information bits are the N control bits, or the N information bits are obtained by scrambling the N control bits.

In this application, when the padding operation is performed on the initial EDMG Header sequence, 0 bits may be filled on the basis of the initial EDMG Header sequence. The padding operation is to meet a requirement of a quantity of bits in subsequent LDPC encoding. For example, when 1/2 LDPC encoding needs to be performed, and a sequence obtained after encoding needs to meet 672 bits, a quantity of bits in a bit sequence before encoding needs to meet 1/2 of 672, namely, 336, and a quantity of parity check bits generated through 1/2 LDPC encoding is also 1/2 of 672, namely, 336.

203. Perform 1/2 low-density parity-check LDPC encoding on the padded sequence to obtain an encoded sequence. The encoded sequence includes the N control bits, the L padding bits, and N+L parity check bits generated through encoding, and L is a positive integer.

If it is necessary to meet a condition that the sequence obtained after encoding needs to be 672 bits, N+L=336 needs to be met.

204. Constitute a first sequence by using N information bits and a first part of the parity check bits in the encoded sequence, and obtain a second sequence based on the N information bits and a second part of the parity check bits in the encoded sequence, where a length of the first sequence is the same as a length of the second sequence, and check bits included in the first part of the parity check bits are not completely the same as those included in the second part of the parity check bits.

If N>112, it is assumed that the EDMG Header sequence, that needs to be transmitted is $b_1, b_2, ..., b_N$, and a sequence obtained after scrambling processing is performed on the sequence $b_1, b_2, ..., b_N$ is $q_1, q_2, ..., q_N$. The padded sequence is $q_1, q_2, ..., q_N, 0_1, 0_2, ..., 0_{336-N}$, and the encoded sequence is $q_1, q_2, ..., q_N, 0_1, 0_2, ..., 0_{336-N}, p_1, p_2, ..., p_{336}$. $p_1, p_2, ..., p_{336}$ is a parity check bit sequence generated through 1/2 LDPC encoding. The first sequence constructed from the foregoing encoded sequence may be $q_1, q_2, ..., q_N, p_1, p_2, ..., p_{448-N}$, a third sequence constructed from the foregoing encoded sequence may be $q_1, q_2, ..., q_N, p_1, p_2, ..., p_{560-2N}, p_{448-N+1}, ... p_{336}$, and the second sequence may be obtained after an exclusive OR operation or interleaving processing is performed on the third sequence.

In an example of the present invention, the third sequence may be directly used as the second sequence, and no processing is performed. However, performance gains obtained when the third sequence is directly used as the second sequence are slightly inferior to those obtained when the second sequence is obtained by processing the third sequence.

In an embodiment of the present invention, both the length of the first sequence and the length of the second sequence are 448.

In this application, the exclusive OR operation may be performed by using a sequence {0, 1, 0, 1, ..., 0, 1} or a sequence {1, 0, 1, ..., 1, 0}, or may be performed by using a pseudo-random sequence. This is not limited in this application.

In an embodiment of the present invention, the first part of the parity check bits constitutes a first set, the second part of the parity check bits constitutes a second set, and a union set of the first set and the second set constitutes all the parity check bits. In this way, the parity check bits are fully used when the first sequence and the second sequence are constructed, so that frame transmission performance can be improved. An intersection set of the first set and the second set constitutes a third set. A quantity of bits in the third set is closer to a total quantity of parity check bits, fewer parity check bits are discarded when the sequence is constructed, and the frame transmission performance may be better.

205. Modulate the first sequence to obtain a first modulated sequence, and modulate the second sequence to obtain a second modulated sequence.

In an embodiment of the present invention, binary phase shift keying (Binary Phase Shift Keying, BPSK) modulation or $\pi/2$ BPSK modulation may be used to modulate the first sequence and the second sequence, to obtain the corresponding first modulated sequence and second modulated sequence.

206. Insert a guard interval GI between the first modulated sequence and the second modulated sequence, obtain an encoded and modulated EDMG Header sequence based on a sequence obtained after the guard interval is inserted, combine the encoded and modulated EDMG Header sequence and to-be-sent data to constitute a frame, and transmit the frame.

The guard interval is inserted between the first modulated sequence and the second modulated sequence, and this may be distinguished from a Header design in 802.1 1ad. In the 802.11ad design, two 224-bit sequences are constructed, the two 224-bit sequences are directly combined to constitute one 448-bit sequence, and no guard interval is inserted between the two 224-bit sequences. Then, reverse ordering is performed on the 448-bit sequence to constitute another 448-bit sequence, and a guard interval is inserted between the two 448-bit sequences, to obtain an encoded and modulated EDMG Header sequence. The encoded and modulated EDMG Header sequence and to-be-sent data are combined to constitute a frame, and the frame is transmitted. However, in this application, 448 bits are directly constructed, and an implementation is easier.

In addition, in an embodiment of the present invention, a guard interval may be further inserted before the first modulated sequence and a guard interval may be further inserted after the second modulated sequence. During transmission of a frame obtained in such a manner, frame transmission reliability can be improved.

In this application, uniform 1/2 LDPC encoding is performed after the padding operation is performed on the control bits in the EDMG Header sequence, and two sequences that each include all the control bits are directly obtained based on the encoded sequence obtained after encoding. Then, modulation is performed on the two sequences to obtain the frame, and the frame is transmitted. Such a retransmission design can improve frame transmission performance.

In an embodiment of the present invention, the method in FIG. 3 may be performed by a transmitter in a single carrier system. After receiving the frame, a receiver may divide the received frame into blocks, delete a cyclic prefix in each block, and perform Fourier transform on a data group obtained after the cyclic prefix is deleted, to transform the data group to frequency domain. Then, frequency domain equalization processing is performed, by using frequency domain channel information, on the data transformed to frequency domain, and inverse Fourier transform is performed on data obtained after frequency domain equalization, to transform the data back to time domain, so as to perform demodulation and decoding processing on a time-domain signal.

Specifically, when performing demodulation and decoding on the frame, the receiver may separately perform demodulation on the two received sequences whose lengths are 448 to obtain two corresponding log-likelihood ratios; combine the two log-likelihood ratios to obtain one or more sequences; combine the one or more sequences, and insert 0 bits between the sequences, so that a length of a combined sequence is 672; perform LDPC decoding on the sequence whose length is 672 to obtain 336 bit valuations; and determine, from the 336 bit valuations, valuations of the N control bits in the EDMG Header sequence sent by the transmitter.

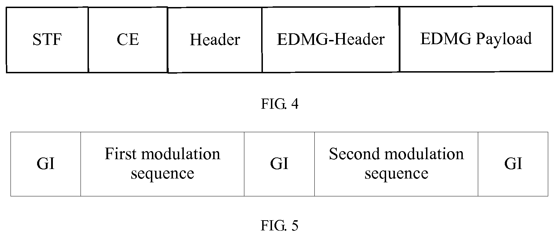

FIG. 4 is a schematic structural diagram of a frame in the 802.11ay protocol according to an embodiment of the present invention. In 802.11ay standard discussion, a frame structure includes a short training field (Legacy Short Training field, STF), a channel estimation (Channel Estimation, CE) field, a header (Header) field, an EDMG-Header field, and an EDMG payload (Payload) field. In this application, processing such as encoding and modulation may be performed on an EDMG-Header based on a design of the EDMG-Header, and a frame is output. The STF is used for synchronization, frequency offset estimation, and automatic gain control (Auto Gain Control, AGC) field adjustment, and a receiver can implement synchronization based on a received STF signal. The CE field is used for channel estimation, to be specific, the receiver may perform channel estimation based on a received CE signal. The Header field is used to represent an indication signal, for example, may be used to represent a modulation manner of the data frame, and the like. The EDMG-Header field is used to indicate control signaling in 802.11ay. The EDMG Payload filed is used to transmit data in 80.211ay. The receiver may perform demodulation, decoding, encoding and the like on the data based on a received Header signal and EDMG-Header signal. This application mainly describes a design of the EDMG-Header.

FIG. 5 is a schematic diagram of an EDMG Header field in a structure of a frame in the 802.11ay protocol according to an embodiment of the present invention. The EDMG Header field in this application includes two consecutive sequences between which a guard interval (guard interval, GI) is inserted, as shown in FIG. 5. The two sequences are a first modulated sequence and a second modulated sequence, and both a length of the first modulated sequence and a length of the second modulated sequence are 448. In other words, the first modulated sequence includes 448 symbols, and the second modulated sequence includes 448 symbols. In this application, a GI needs to be inserted before the first modulated sequence, a GI needs to be inserted between the first modulated sequence and the second modulated sequence, and a GI needs to be inserted after the second modulated sequence. The GI may include 64 symbols (symbols). The inserted guard interval may reduce inter Symbol interference (Inter Symbol Interference, ISI) and inter-channel interference (Inter Channel Interference, ICI) caused by multipath. A receiver may further perform channel equalization and phase deviation estimation based on the guard interval.

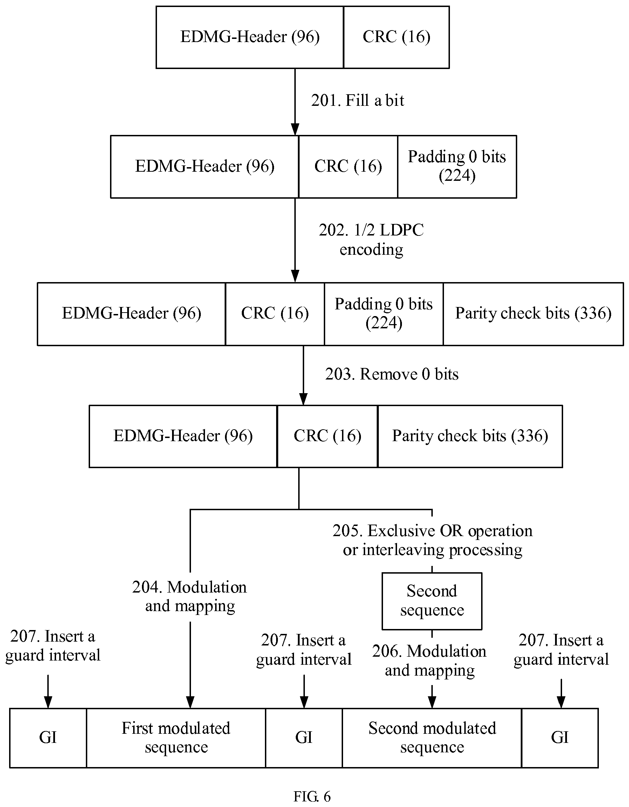

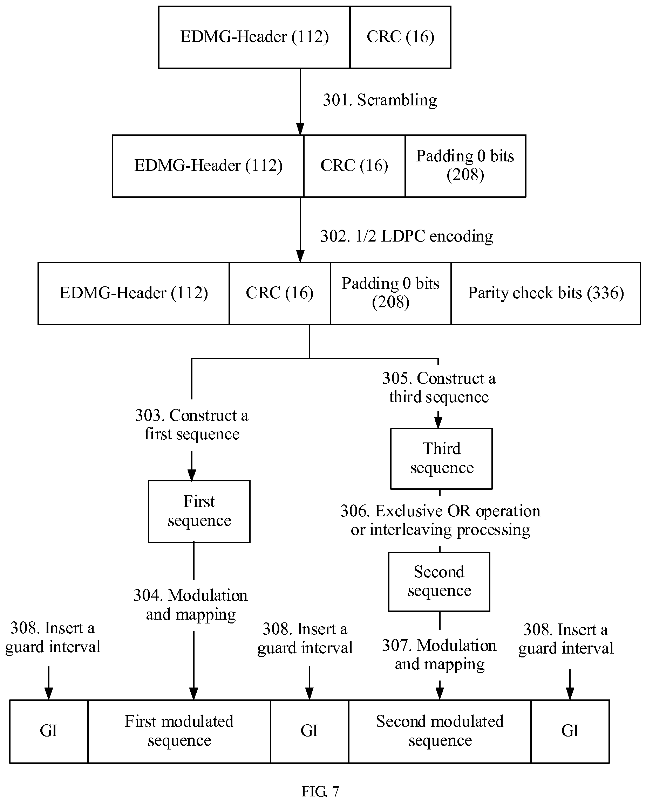

The foregoing describes in detail the frame transmission methods according to the embodiments of the present invention from a perspective of a transmitter. The following describes in detail the frame transmission methods according to this application with reference to specific embodiments in FIG. 6 and FIG. 7. It should be noted that these examples are merely intended to help a person skilled in the art better understand this application, but are not intended to limit the scope of this application. In FIG. 6 and FIG. 7, N=112 and N=128 are respectively used as examples for description.

FIG. 6 is a schematic flowchart of a frame transmission method according to another embodiment of the present invention. The method in FIG. 6 may be performed by a transmitter. The transmitter herein may be the AP in FIG. 1, or may be a STA in FIG. 1. In FIG. 6, an example in which an initial EDMG Header sequence includes 112 control bits is used for description.

The initial EDMG Header sequence includes 112 control bits: $b_1$, $b_2$, ..., $b_{112}$. The 112 control bits may include information bits and CRC bits. A quantity of information bits and a quantity of check bits are not limited. Herein, 96 information bits and 16 CRC check bits are used as an example for description. In FIG. 6, EDMG Header (96) is used to indicate that the initial EDMG Header sequence includes 96 information bits, and CRC (16) is used to indicate that the initial EDMG Header sequence includes 16 CRC bits. Herein, the 96 information bits and the 16

CRC bits are denoted as $b_1$, $b_2$, ..., $b_{112}$. An initial EDMG Header sequence in 802.11ay discussion includes 82 information bits. The information bits herein may be extended, for example, 14 information bits are filled to constitute 96 information bits in this application. If a quantity of bits that need to be transmitted is less than 112, some bits may be filled in information bits to constitute 96 information bits.

Scrambling is performed on the 112 control bits $b_1$, $b_2$, ..., $b_{112}$ to obtain a scrambled sequence $q_1$, $q_2$, ..., $q_{112}$. It should be understood that scrambling in this application is an optional step, and scrambling processing may not be performed. In other words, operations in the following procedure may be directly performed on the sequence $b_1$, $b_2$, ..., $b_{112}$, or the operations in the following procedure may be performed on the scrambled sequence $q_1$, $q_2$, ..., $q_{112}$. The following provides description by using an example in which processing is performed on the scrambled sequence.

201. bits padding.

A padding operation is performed on the sequence $q_1$, $q_2$, ..., $q_{112}$, so that a length of a padded sequence obtained after padding is 336. For example, 0 bits are padded to obtain a padded sequence $q_1$, $q_2$,..., $q_{112}$, $0_1$, $0_2$, ..., $0_{224}$.

202. Perform 1/2 LDPC encoding on a padded sequence obtained after padding.

1/2 LDPC encoding is performed on the padded sequence $q_1$, $q_2$, ..., $q_{112}$, $0_1$, $0_2$, ..., $0_{224}$, to obtain an encoded sequence $q_1$, $q_2$, ..., $q_{112}$, $0_1$, $0_2$, ..., $0_{224}$, $p_1$, $p_2$, ..., $p_{336}$. $p_1$, $p_2$, ..., $p_{336}$ are parity check bits generated through encoding.

203. Remove 0 bits.

The 0 bits in the encoded sequence are removed, to obtain a first sequence $q_1$, $q_2$, ..., $q_{112}$, $p_1$, $p_2$, ..., $p_{336}$. The first sequence includes 96 information bits, 16 CRC bits, and 336 check bits.

204. Perform modulation and mapping on a first sequence to obtain a first modulated sequence.

$\pi/2$ BPSK or BPSK modulation and mapping processing are performed on the first sequence $q_1$, $q_2$,..., $q_{112}$, $p_1$, $p_2$, ..., $p_{336}$ to obtain the first modulated sequence.

205. Perform an exclusive OR operation or interleaving processing on the first sequence to obtain a second sequence.

The exclusive OR operation or interleaving processing is performed on the first sequence $q_1$, $q_2$, ..., $q_{112}$, $p_1$, $p_2$, ..., $p_{336}$ to obtain the second sequence. For example, scrambling processing may be performed on the first sequence $q_1$, $q_2$, ..., $q_{112}$, $p_1$, $p_2$, ..., $p_{336}$ by using a pseudo-random sequence to obtain the second sequence. For another example, the exclusive OR operation may be performed on the first sequence by using a sequence {0, 1, 0, 1, ..., 0, 1} or {1, 0, 1, ..., 1, 0}, where 0 and 1 are alternately arranged in the sequence {0, 1, 0, 1, ..., 0, 1} or {1, 0, 1, ..., 1, 0}, a length of the sequence is 448, and both a quantity of 0s and a quantity of 1s are 224. The sequence {0, 1, 0, 1, ..., 0, 1} may also be written as mod (k, 2), and the sequence {1, 0, 1, ..., 1, 0} may be written as mod (k+1, 2), where mod () indicates a modulo operation, and k is a positive integer from 0 to 447. For another example, a simple interleaver may be used to perform interleaving processing on the first sequence $q_1$, $q_2$, ..., $q_{112}$, $p_1$, $p_2$, ..., $p_{336}$, and reverse ordering is performed on the first sequence, to obtain the second sequence $p_{336}$, $p_{335}$,..., $p_2$, $p_1$, $q_{112}$,... $q_2$, $q_1$.

Step 205 is an optional step. In an embodiment of the present invention, the first sequence obtained in step 203 may also be directly used as the second sequence, and an operation in step 205 is not performed. After the first sequence is obtained, step 204 and step 206 are simultaneously performed, and modulation and mapping are performed on the first sequence. In other words, the second sequence is equal to the first sequence, and a second modulated sequence is also equal to the first modulated sequence.

206. Perform modulation and mapping on the second sequence to obtain a second modulated sequence.

$\pi/2$ BPSK or BPSK modulation and mapping processing are performed on the second sequence to obtain the second modulated sequence.

207. Insert a guard interval before the first modulated sequence, insert a guard interval between the first modulated sequence and the second modulated sequence, and insert a guard interval after the second modulated sequence.

The guard interval is inserted before the first modulated sequence, the guard interval is inserted between the first modulated sequence and the second modulated sequence, and the guard interval is inserted after the second modulated sequence. As shown in FIG. 5, precisely, a guard interval is inserted before the first modulated sequence, a guard interval is inserted between the first modulated sequence and the second modulated sequence, and a guard interval is inserted after the second modulated sequence. The guard interval may include 64 symbols.

After the guard interval is inserted, two consecutive 448-bit modulated sequences between which the guard interval is inserted are constituted. The guard interval, the two modulated sequences, and to-be-sent data constitute a frame, and the frame may be transmitted.

In an existing I/Q solution in 802.11ay, because an initial EDMG Header includes 82 information bits, in order to use an existing method for transmitting 64 bits in 802.11ad, 30 padding bits are filled in the EDMG Header to make up 128 bits. The 128 bits are divided into two 64-bit sequences, and an EDMG Header modulation solution in 802.11ad is separately performed on the two 64-bit sequences. In the solution in this application, 30 padding bits are not necessarily required. Therefore, 16 padding bits may not be transmitted but performance gains may be increased by 2 dB in the solution.

In an embodiment of the present invention, after the transmitter transmits the frame, a receiver may receive the frame, and perform demodulation and decoding on the frame. It is assumed that the first sequence and the second sequence are respectively represented by using $x(n)$ and $y(n)$, where n=0, 1, 2, ..., 447. The receiver may perform demodulation and decoding on the frame in the following manner: separately performing demodulation on $x(n)$ and $y(n)$ to obtain corresponding log-likelihood ratios (log-likelihood Rate, LLR), namely, $LLR_x(n)$ and $LLR_y(n)$; combining $LLR_x(n)$

and $LLR_y(n)$ to obtain $LLR(n) = \dfrac{1}{2}(LLR_x(n) + LLR_y(n))$ ; adding a bit 0 in $LLR(n)$ to form a new sequence $LLR'$

$= [LLR(1),..., LLR(112),0_1,0_2,...,0_{224},LLR(113),..., LLR(448)]$ whose length is 672; and inputting the sequence $LLR'$ into an LDPC decoder to obtain 336 bit valuations $b_1, b_2, ..., b_{336}$, where the first 112 bit valuations are valuations of the 112 control bits in the EDMG Header sequence sent by the transmitter.

FIG. 7 is a schematic flowchart of a frame transmission method according to another embodiment of the present invention. The method in FIG. 7 may be performed by a transmitter. The transmitter herein may be the AP in FIG. 1, or may be a STA in FIG. 1. In FIG. 7, an example in which an initial EDMG Header sequence includes 128 control bits is used for description. It should be understood that when a quantity of control bits is greater than 112, the frame transmission method shown in FIG. 7 may be used.

The initial EDMG Header sequence includes 128 control bits: $b_1, b_2, ..., b_{128}$. The 128 control bits may include information bits and CRC bits. A quantity of information bits and a quantity of check bits are not limited. Herein, 112 information bits and 16 CRC check bits are used as an example for description. In FIG. 7, EDMG Header (112) is used to indicate that the initial EDMG Header sequence includes 112 information bits, and CRC (16) is used to indicate that the initial EDMG Header sequence includes 16 CRC bits. An EDMG Header sequence in 802.11ay discussion includes 82 information bits. The information bits herein may be extended, for example, 30 information bits are filled to constitute 112 information bits in this application. Herein, the 112 information bits and the 16 CRC bits are denoted as $b_1, b_2, ..., b_{128}$.

Scrambling is performed on the 128 control bits $b_1, b_2, ..., b_{128}$ to obtain a scrambled sequence $q_1, q_2,..., q_{128}$. It should be understood that scrambling in this application is an optional step, and scrambling processing may not be performed. In other words, operations in the following procedure may be directly performed on the sequence $b_1, b_2, ..., b_{128}$, or the operations in the following procedure may be performed on the scrambled sequence $q_1, q_2, ..., q_{128}$. The following provides description by using an example in which processing is performed on the scrambled sequence $q_1, q_2, ..., q_{128}$.

301. bits padding.

A padding operation is performed on the sequence $q_1, q_2, ..., q_{128}$, so that a length of a padded sequence obtained after padding is 336. For example, 0 bits are padded to obtain a padded sequence $q_1, q_2, ..., q_{128}, 0_1, 0_2, ..., 0_{208}$.

302. Perform 1/2 LDPC encoding on a padded sequence obtained after padding.

1/2 LDPC encoding is performed on the padded sequence $q_1, q_2, ..., q_{128}, 0_1, 0_2,..., 0_{208}$, to obtain an encoded sequence $q_1, q_2,..., q_{128}, 0_1, 0_2,..., 0_{208}, p_1, p_2,..., p_{336}$.

303. Construct a first sequence.

The 0 bits in the encoded sequence are removed, and the 128 information bits and a first part of the parity check bits in the encoded sequence constitute the first sequence. A length of the first sequence is exactly 448. For example, the first sequence is $q_1, q_2, ..., q_{128}, p_1, p_2, ..., p_{320}$. Herein, the 128 information bits in the encoded sequence are $q_1, q_2, ..., q_{128}$.

304. Perform modulation and mapping on the first sequence to obtain a first modulated sequence.

$\pi/2$ BPSK or BPSK modulation and mapping processing are performed on the first sequence $q_1, q_2, ..., q_{112}, p_1, p_2, ..., p_{320}$ to obtain the first modulated sequence.

305. Construct a third sequence.

The 0 bits in the encoded sequence are removed, and the 128 information bits and a second part of the parity check bits in the encoded sequence constitute the third sequence. A length of the third sequence is also exactly 448. For example, the third sequence is $q_1, q_2, ..., q_{128}, p_1, p_2, p_{304}, p_{321}, ..., p_{336}$

306. Perform an exclusive OR operation or interleaving processing on the third sequence to obtain a second sequence.

The exclusive OR operation or interleaving processing is performed on the third sequence $q_1, q_2, ..., q_{128}, p_1, p_2, ..., p_{304}, p_{321}, ..., p_{336}$ to obtain the second sequence. For example, scrambling processing may be performed, by using a pseudo-random sequence, on the third sequence $q_1, q_2, ..., q_{128}, p_1, p_2, ..., p_{304}, p_{321}, ..., p_{336}$, to obtain the second sequence. For another example, the exclusive OR operation may be performed, by using a sequence {0, 1, 0, 1, ..., 0, 1}, on the third sequence, where 0 and 1 are alternately arranged in the sequence {0, 1, 0, 1, ..., 0, 1}, and a length of the sequence is 448. The sequence {0, 1, 0, 1, ..., 0, 1} may also be written as mod (k, 2), where mod () indicates a modulo operation, and k is a positive integer from 0 to 447. For another example, the exclusive OR operation may be performed, by using a sequence {1, 0, 1, ..., 1, 0}, on the third sequence, where 0 and 1 are alternately arranged in the sequence {1, 0, 1, ..., 1, 0}, and a length of the sequence is 448. The sequence {1, 0, 1, ..., 1, 0} may also be written as mod (k+1, 2), where mod () indicates a modulo operation, and k is a positive integer from 0 to 447. For another example, a simple interleaver may be used to perform interleaving processing on the third sequence $q_1, q_2, ..., q_{128}, p_1, p_2, ..., p_{304}, p_{321}, ..., p_{336}$, and reverse ordering is performed on the third sequence, to obtain the second sequence $p_{336}, p_{335}, ..., p_{321}, p_{304}, ..., p_2, p_1, q_{128}, ... q_2, q_1$.

It should be understood that step 306 is an optional step. In an embodiment of the present invention, the third sequence constructed in step 305 may also be directly used as the sequence on which modulation and mapping need to be performed, step 307 is directly performed after step 305, and modulation and mapping are performed on the sequence to obtain a second modulated sequence. In other words, the constructed third sequence is considered as the second sequence on which encoding and modulation need to be performed.

307. Perform modulation and mapping on the second sequence to obtain a second modulated sequence.

$\pi/2$ BPSK or BPSK modulation and mapping processing are performed on the second sequence $p_{336}, p_{335}, ..., p_{321}, p_{304}, ..., p_2, p_1, q_{128}, ... q_2, q_1$ to obtain the second modulated sequence.

308. Insert a guard interval before the first modulated sequence, insert a guard interval between the first modulated sequence and the second modulated sequence, and insert a guard interval after the second modulated sequence.

The guard interval is inserted before the first modulated sequence, the guard interval is inserted between the first modulated sequence and the second modulated sequence, and the guard interval is inserted after the second modulated sequence. As shown in FIG. 5, precisely, a guard interval is inserted before the first modulated sequence, a guard interval is inserted between the first modulated sequence and the second modulated sequence, and a guard interval is inserted after the second modulated sequence. The guard interval may include 64 symbols.

After the guard interval is inserted, two consecutive 448-bit modulated sequences between which the guard interval is inserted are constituted. The guard interval, the two modulated sequences and to-be-sent data constitute a frame, and the frame may be transmitted.

In this application, encoding, modulation, and mapping are performed on the EDMG Header sequence at a time, and there is no need to use a solution in 802.11ad in which bits are divided into a plurality of 64-bits sequences, so that frame retransmission can be implemented, and frame transmission performance can be improved. A simulation result shows that gains can be improved in the technical solutions in this application when compared with the solution in 802.11ad. For example, gains of 1 dB can be improved when 128 bits are transmitted.

In an embodiment of the present invention, after the transmitter transmits the frame, a receiver may receive the frame, and perform demodulation and decoding on the frame. It is assumed that the first sequence and the second sequence are respectively represented by using $x(n)$ and $y(n)$, where n=0, 1, 2, ..., 447. The receiver may perform demodulation and decoding on the frame in the following manner: separately performing demodulation on $x(n)$ and $y(n)$ to obtain $LLR_x(n)$ and $LLR_y(n)$ ; combining $LLR_x(n)$ and $LLR_y(n)$ to obtain four sequences: $LLR_1(n)$, $LLR_2(n)$, $LLR_3(n)$, and $LLR_4(n)$, where composition of the four sequences is as follows:

EP 3 462 651 B1

$$LLR_1(n) = \frac{1}{2}(LLR_x(n) + LLR_y(n)) \quad , n=0, 1, 2, …, 127;$$

$$LLR_2(n) = \frac{1}{2}(LLR_x(n+128) + LLR_y(n+128)) \quad , n=0, 1, 2, …, 303;$$

$$LLR_3(n) = LLR_x(n+128+304) \quad , n=0, 1, 2, …, 15;$$

and

$$LLR_4(n) = LLR_y(n+128+304) \quad , n=0, 1, 2, …,15;$$

adding a bit 0 in $LLR_1(n)$, $LLR_2(n)$, $LLR_3(n)$, and $LLR_4(n)$ to form a new sequence $LLR' = [LLR_1, LLR_2, 0_1, 0_2, …, 0_{208}, LLR_3, LLR_4,]$ whose length is 672; and inputting the sequence $LLR'$ into an LDPC decoder to obtain 336 bit valuations $b_1, b_2, …, b_{336}$, where the first 128 bit valuations are valuations of the 128 control bits in the EDMG Header sequence sent by the transmitter.

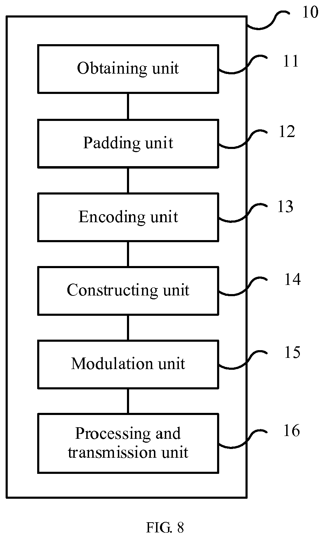

The foregoing describes in detail the frame transmission methods according to this application with reference to FIG. 1 to FIG. 7. The following describes frame transmission apparatuses according to this application with reference to block diagrams of frame transmission apparatuses in FIG. 8 to FIG. 11.

FIG. 8 is a schematic structural diagram of a frame transmission apparatus according to an embodiment of this application. The apparatus in FIG. 8 may perform methods performed by a transmitter in procedures of FIG. 2 and FIG. 6. The apparatus 10 in FIG. 8 includes an obtaining unit 11, a padding unit 12, an encoding unit 13, a constructing unit 14, a modulation unit 15, and a processing and transmission unit 16.

The obtaining unit 11 is configured to obtain an initial enhanced directional multi-gigabit header EDMG Header sequence. The initial EDMG Header sequence includes N control bits, and N is a positive integer.

The padding unit 12 is configured to perform a padding operation on the initial EDMG Header sequence obtained by the obtaining unit, to obtain a padded sequence. The padded sequence includes N information bits and L padding bits, and the N information bits are the N control bits, or the N information bits are obtained by scrambling the N control bits.

The encoding unit 13 is configured to perform 1/2 low-density parity-check LDPC encoding on the padded sequence obtained by the padding unit, to obtain an encoded sequence. The encoded sequence includes the N information bits, the L padding bits, and N+L parity check bits generated through encoding, and L is a positive integer.

The constructing unit 14 is configured to: constitute a first sequence by using the N information bits and all the parity check bits in the encoded sequence obtained by the encoding unit, and obtain a second sequence based on the first sequence. A length of the first sequence is the same as a length of the second sequence.

The modulation unit 15 is configured to separately perform modulation on the first sequence and the second sequence that are obtained by the constructing unit, to obtain a first modulated sequence and a second modulated sequence.

The processing and transmission unit 16 is configured to: insert a guard interval GI between the first modulated sequence and the second modulated sequence that are obtained by the modulation unit, obtain an encoded and modulated EDMG Header sequence based on a sequence obtained after the guard interval is inserted, combine the encoded and modulated EDMG Header sequence and to-be-sent data to obtain a frame, and transmit the frame.

In this application, uniform 1/2 LDPC encoding is performed after the padding operation is performed on the control bits in the EDMG Header sequence, and two sequences that each include all the control bits are directly obtained based on the encoded sequence obtained after encoding. Then, modulation is performed on the two sequences to obtain the frame, and the frame is transmitted. Such a retransmission design can improve frame transmission performance.

For the frame transmission apparatus in this application, refer to the procedures of the corresponding frame transmission methods in this application, and the units/modules in the apparatus and other operations and/or functions are respectively intended to implement the corresponding procedures in the methods. For brevity, details are not described herein.

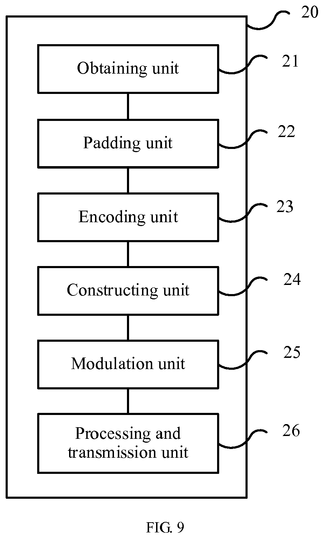

FIG. 9 is a schematic structural diagram of a frame transmission apparatus according to another embodiment of the present invention. The apparatus in FIG. 9 may perform methods performed by a transmitter in procedures of FIG. 3 and FIG. 7. The apparatus 20 in FIG. 9 includes an obtaining unit 21, a padding unit 22, an encoding unit 23, a constructing unit 24, a modulation unit 25, and a processing and transmission unit 26.

The obtaining unit 21 is configured to obtain an initial enhanced directional multi-gigabit header EDMG Header sequence. The initial EDMG Header sequence includes N control bits, and N is a positive integer.

The padding unit 22 is configured to perform a padding operation on the initial EDMG Header sequence obtained by the obtaining unit, to obtain a padded sequence. The padded sequence includes N information bits and L padding bits, and the N information bits are the N control bits, or the N information bits are obtained by scrambling the N control bits.

The encoding unit 23 is configured to perform 1/2 low-density parity-check LDPC encoding on the padded sequence obtained by the padding unit, to obtain an encoded sequence. The encoded sequence includes the N information bits, the L padding bits, and N+L parity check bits generated through encoding, and L is a positive integer.

The constructing unit 24 is configured to: constitute a first sequence by using the N information bits and a first part of the parity check bits in the encoded sequence obtained by the encoding unit, and obtain a second sequence based on the N information bits and a second part of the parity check bits in the encoded sequence obtained by the encoding unit. A length of the first sequence is the same as a length of the second sequence, and bits included in the first part of the parity check bits are not completely the same as those included in the second part of the parity check bits.

The modulation unit 25 is configured to separately perform modulation on the first sequence and the second sequence that are obtained by the constructing unit, to obtain a first modulated sequence and a second modulated sequence.

The processing and transmission unit 26 is configured to: insert a guard interval GI between the first modulated sequence and the second modulated sequence that are obtained by the modulation unit, obtain an encoded and modulated EDMG Header sequence based on a sequence obtained after the guard interval is inserted, combine the encoded and modulated EDMG Header sequence and to-be-sent data to obtain a frame, and transmit the frame.

In this application, uniform 1/2 LDPC encoding is performed after the padding operation is performed on the control bits in the EDMG Header sequence, and two sequences that each include all the control bits are directly obtained based on the encoded sequence obtained after encoding. Then, modulation is performed on the two sequences to obtain the frame, and the frame is transmitted. Such a retransmission design can improve frame transmission performance.

For the frame transmission apparatus in this application, refer to the procedures of the corresponding frame transmission methods in this application, and the units/modules in the apparatus and other operations and/or functions are respectively intended to implement the corresponding procedures in the methods. For brevity, details are not described herein.

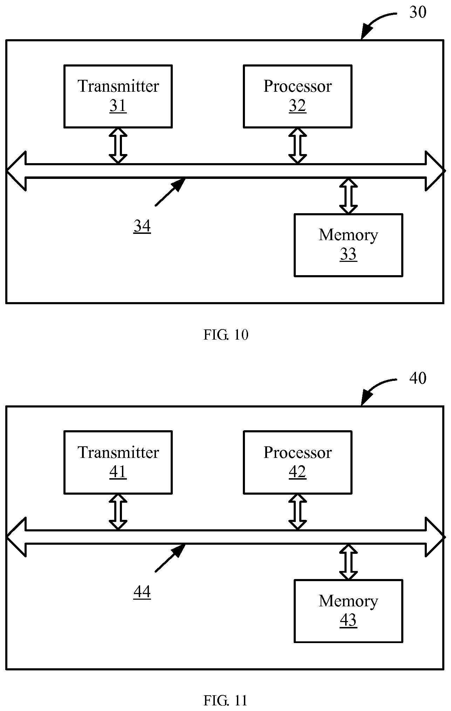

FIG. 10 is a schematic structural diagram of a frame transmission apparatus according to another embodiment of the present invention. The apparatus in FIG. 10 may perform methods performed by a transmitter in procedures of FIG. 2 and FIG. 6. The apparatus 30 in FIG. 10 includes a transmitter 31, a processor 32, and a memory 33. The processor 32 controls an operation of the apparatus 30 and may be configured to process a signal. The memory 33 may include a read-only memory and a random access memory, and provide an instruction and data for the processor 32. All components of the apparatus 30 are coupled together by using a bus system 34. In addition to a data bus, the bus system 34 further includes a power bus, a control bus, and a status signal bus. However, for clarity of description, various buses are marked as the bus system 34 in the figure.

The methods disclosed in this application may be applied to the processor 32, or may be implemented by the processor 32. In an implementation process, each step of the foregoing methods may be completed by using an integrated logic circuit of hardware in the processor 32 or an instruction in a form of software. The processor 32 may be a general purpose processor, a digital signal processor, an application-specific integrated circuit, a field programmable gate array or another programmable logic device, a discrete gate or a transistor logic device, or a discrete hardware component, and may implement or perform methods, steps, and logical block diagrams that are disclosed in this application. The general purpose processor may be a microprocessor, any conventional processor, or the like. The steps of the methods disclosed in this application may be directly performed by a hardware processor, or may be performed by using a combination of hardware and software modules in the processor. The software module may be located in a mature storage medium in the field, such as a random access memory, a flash memory, a read-only memory, a programmable read-only memory, an electrically erasable programmable memory, or a register. The storage medium is located in the memory 33, and the processor 32 reads information in the memory 33 and implements the steps of the foregoing methods in combination with hardware of the processor 32.

Specifically, the processor 32 may obtain an initial EDMG Header sequence, perform a padding operation on the initial EDMG Header sequence to obtain a padded sequence, and perform 1/2 low-density parity-check LDPC encoding on the padded sequence to obtain an encoded sequence; constitute a first sequence by using N information bits and all check bits in the encoded sequence, and obtain a second sequence based on the first sequence; modulate the first sequence to obtain a first modulated sequence, and modulate the second sequence to obtain a second modulated sequence; and obtain a frame based on the first modulated sequence and the second modulated sequence. The initial EDMG Header sequence includes N control bits, and N is a positive integer. The padded sequence includes the N information bits and L padding bits, and the N information bits are the N control bits, or the N information bits are obtained by scrambling the N control bits. The encoded sequence includes the N information bits, the L padding bits, and N+L check bits generated through encoding, and L is a positive integer. A length of the first sequence is the same as a length of the second sequence.

The processor 32 may further insert a guard interval GI between the first modulated sequence and the second modulated sequence, obtain an encoded and modulated EDMG Header sequence based on a sequence obtained after the guard interval is inserted, and combine the encoded and modulated EDMG Header sequence and to-be-sent data to obtain the frame.

The transmitter 31 may transmit the frame.

In this application, uniform 1/2 LDPC encoding is performed after the padding operation is performed on the control bits in the EDMG Header sequence, and two sequences that each include all the control bits are directly obtained based on the encoded sequence obtained after encoding. Then, modulation is performed on the two sequences to obtain the frame, and the frame is transmitted. Such a retransmission design can improve frame transmission performance.

For the frame transmission apparatus in this application, refer to the procedures of the frame transmission methods in this application, and the units/modules in the apparatus and other operations and/or functions are respectively intended to implement the corresponding procedures in the methods. For brevity, details are not described herein.

FIG. 11 is a schematic structural diagram of a frame transmission apparatus according to another embodiment of the present invention. The apparatus in FIG. 11 may perform methods performed by a transmitter in procedures of FIG. 3 and FIG. 7. The apparatus 40 in FIG. 11 includes a transmitter 41, a processor 42, and a memory 43. The processor 42 controls an operation of the apparatus 40 and may be configured to process a signal. The memory 43 may include a read-only memory and a random access memory, and provide an instruction and data for the processor 42. All components of the apparatus 40 are coupled together by using a bus system 44. In addition to a data bus, the bus system 44 further includes a power bus, a control bus, and a status signal bus. However, for clarity of description, various buses are marked as the bus system 44 in the figure.

The methods disclosed in this application may be applied to the processor 42, or may be implemented by the processor 42. In an implementation process, each step of the foregoing methods may be completed by using an integrated logic circuit of hardware in the processor 42 or an instruction in a form of software. The processor 42 may be a general purpose processor, a digital signal processor, an application-specific integrated circuit, a field programmable gate array or another programmable logic device, a discrete gate or a transistor logic device, or a discrete hardware component, and may implement or perform methods, steps, and logical block diagrams that are disclosed in this application. The general purpose processor may be a microprocessor, any conventional processor, or the like. The steps of the methods disclosed in this application may be directly performed by a hardware processor, or may be performed by using a combination of hardware and software modules in the processor. The software module may be located in a mature storage medium in the field, such as a random access memory, a flash memory, a read-only memory, a programmable read-only memory, an electrically erasable programmable memory, or a register. The storage medium is located in the memory 43, and the processor 42 reads information in the memory 43 and implements the steps of the foregoing methods in combination with hardware of the processor 42.

Specifically, the processor 42 may obtain an initial EDMG Header sequence, perform a padding operation on the initial EDMG Header sequence to obtain a padded sequence, and perform 1/2 low-density parity-check LDPC encoding on the padded sequence to obtain an encoded sequence; constitute a first sequence by using N information bits and a first part of check bits in the encoded sequence, and obtain a second sequence based on the N information bits and a second part of the check bits in the encoded sequence; modulate the first sequence to obtain a first modulated sequence, and modulate the second sequence to obtain a second modulated sequence; and obtain a frame based on the first modulated sequence and the second modulated sequence. The initial EDMG Header sequence includes N control bits, and N is a positive integer. The padded sequence includes the N information bits and L padding bits, and the N information bits are the N control bits, or the N information bits are obtained by scrambling the N control bits. The encoded sequence includes the N information bits, the L padding bits, and N+L check bits generated through encoding, and L is a positive integer. A length of the first sequence is the same as a length of the second sequence. Check bits included in the first part of the check bits are not completely the same as those included in the second part of the check bits.

The processor 42 may further insert a guard interval GI between the first modulated sequence and the second modulated sequence, obtain an encoded and modulated EDMG Header sequence based on a sequence obtained after the guard interval is inserted, and combine the encoded and modulated EDMG Header sequence and to-be-sent data to obtain the frame.

The transmitter 41 may transmit the frame.

In this application, uniform 1/2 LDPC encoding is performed after the padding operation is performed on the control bits in the EDMG Header sequence, and two sequences that each include all the control bits are directly obtained based on the encoded sequence obtained after encoding. Then, modulation is performed on the two sequences to obtain the frame, and the frame is transmitted. Such a retransmission design can improve frame transmission performance.

For the frame transmission apparatus in this application, refer to the procedures of the frame transmission methods in this application, and the units/modules in the apparatus and other operations and/or functions are respectively intended to implement the corresponding procedures in the methods. For brevity, details are not described herein.

It should be understood that "one embodiment" or "an embodiment" mentioned in the entire specification means that particular features, structures, or characteristics related to the embodiment are included in at least one embodiment of the present invention. Therefore, "in one embodiment" or "in an embodiment" that appears throughout the entire specification does not necessarily mean a same embodiment. Moreover, the particular features, structures, or characteristics may be combined in one or more embodiments in any proper manner.

It should be understood that the term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

It should be understood that sequence numbers of the foregoing processes do not mean execution sequences in various embodiments of the present invention. The execution sequences of the processes should be determined based on functions and internal logic of the processes, and should not be construed as any limitation on the implementation processes of this application.

A person of ordinary skill in the art may be aware that, in combination with the embodiments disclosed in this specification, method steps and units may be implemented by electronic hardware, computer software, or a combination thereof. To clearly describe interchangeability between the hardware and the software, the foregoing has generally described steps and compositions of each embodiment based on functions. Whether the functions are performed by hardware or software depends on particular applications and design constraint conditions of the technical solutions. A person skilled in the art may use different methods to implement the described functions for each particular application, but it should not be considered that the implementation goes beyond the scope of the present invention.

The method or step described in the embodiments disclosed in this specification may be implemented by hardware, a software program executed by the processor, or a combination of the hardware and the software program. The software program may be stored in a random access memory (Random Access Memory, RAM), a memory, a read-only memory (Read-Only Memory, ROM), an electrically programmable read-only memory (Electrically Programmable Read-Only Memory, EPROM), an electrically erasable programmable read-only memory (Electrically Erasable Programmable Read-Only Memory, EEPROM), a register, a hard disk, a removable magnetic disk, a compact disc read-only memory (Compact Disc Read-Only Memory, CD-ROM), or a storage medium in any other forms well-known in the technical field.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed.

The units described as separate parts may or may not be physically separate, and parts displayed as units may or may not be physical units, may be located in one position, or may be distributed on a plurality of network units. Some or all of the units may be selected based on actual needs to achieve the objectives of the solutions of the embodiments.

In addition, functional units in the embodiments of this application may be integrated into one processing unit, or each of the units may exist alone physically, or two or more units may be integrated into one unit.

The present invention is described in detail with reference to the accompanying drawings and in combination with the example embodiments, but this application is not limited thereto. Various equivalent modifications or replacements can be made to the embodiments of this application by a person of ordinary skill in the art without departing from the essence of this application, and the modifications or replacements shall fall within the scope of the appended claims.

**Claims**

1. A frame transmission method, comprising:

   obtaining an initial enhanced directional multi-gigabit header, EDMG Header, sequence, wherein the initial EDMG Header sequence comprises N control bits, and N is a positive integer;
   performing a padding operation on the initial EDMG Header sequence to obtain a padded sequence, wherein the padded sequence comprises N information bits and L padding bits, and the N information bits are the N control bits, or the N information bits are obtained by scrambling the N control bits;
   performing 1/2 low-density parity-check, LDPC, encoding on the padded sequence to obtain an encoded sequence, wherein the encoded sequence comprises the N information bits, the L padding bits, and N+L parity check bits generated through encoding, and L is a positive integer;

constituting a first sequence by using the N information bits and all the parity check bits in the encoded sequence, and obtaining a second sequence based on the first sequence, wherein a length of the first sequence is the same as a length of the second sequence;

modulating the first sequence to obtain a first modulated sequence, and modulating the second sequence to obtain a second modulated sequence; and

inserting a guard interval, GI, between the first modulated sequence and the second modulated sequence, obtaining an encoded and modulated EDMG Header sequence based on a sequence obtained after the guard interval is inserted, combining the encoded and modulated EDMG Header sequence and to-be-sent data to obtain a frame, and transmitting the frame.

2. The method according to claim 1, wherein a length of the encoded sequence is 672, both the length of the first sequence and the length of the second sequence are 448, and N+L=336.

3. The method according to claim 1 or 2, wherein when N=112, the obtaining a second sequence based on the first sequence comprises:

performing an exclusive OR operation on the first sequence to obtain the second sequence; or
performing interleaving processing on the first sequence to obtain the second sequence;
wherein the performing an exclusive OR operation on the first sequence to obtain the second sequence comprises:

performing the exclusive OR operation on the first sequence by using a pseudo-random sequence to obtain the second sequence; or
performing the exclusive OR operation on the first sequence by using a sequence {0, 1, 0, 1, ..., 0, 1} or a sequence {1, 0, 1, ..., 1, 0} to obtain the second sequence.

4. A frame transmission method, comprising:

obtaining an initial enhanced directional multi-gigabit header, EDMG Header, sequence, wherein the initial EDMG Header sequence comprises N control bits, and N is a positive integer;
performing a padding operation on the initial EDMG Header sequence to obtain a padded sequence, wherein the padded sequence comprises N information bits and L padding bits, and the N information bits are the N control bits, or the N information bits are obtained by scrambling is performed on the N control bits;
performing 1/2 low-density parity-check, LDPC, encoding on the padded sequence to obtain an encoded sequence, wherein the encoded sequence comprises the N information bits, the L padding bits, and N+L parity check bits generated through encoding, and L is a positive integer;
constituting a first sequence by using the N information bits and a first part of the parity check bits in the encoded sequence, and obtaining a second sequence based on the N information bits and a second part of the parity check bits in the encoded sequence, wherein a length of the first sequence is the same as a length of the second sequence, and bits comprised in the first part of the parity check bits are not completely the same as those comprised in the second part of the parity check bits;
modulating the first sequence to obtain a first modulated sequence, and modulating the second sequence to obtain a second modulated sequence; and
inserting a guard interval, GI, between the first modulated sequence and the second modulated sequence, obtaining an encoded and modulated EDMG Header sequence based on a sequence obtained after the guard interval is inserted, combining the encoded and modulated EDMG Header sequence and to-be-sent data to obtain a frame, and transmitting the frame.

5. The method according to claim 4, wherein a length of the encoded sequence is 672, both the length of the first sequence and the length of the second sequence are 448, and N+L=336.

6. The method according to claim 4 or 5, wherein when N>112, the obtaining the second sequence based on the N information bits and a second part of the parity check bits in the encoded sequence comprises:
constituting the second sequence by using the N information bits and the second part of the parity check bits in the encoded sequence.

7. The method according to claim 4 or 5, wherein when N>112, the obtaining the second sequence based on the N information bits and a second part of the parity check bits in the encoded sequence comprises:

constituting a third sequence by using the N information bits and the second part of the parity check bits in the encoded sequence; and

performing an exclusive OR operation or interleaving processing on the third sequence to obtain the second sequence;

wherein the performing an exclusive OR operation or interleaving processing on the third sequence to obtain the second sequence comprises:

performing the exclusive OR operation on the third sequence by using a pseudo-random sequence to obtain the second sequence; or

performing the exclusive OR operation on the third sequence by using a sequence {0, 1, 0, 1, ..., 0, 1} or a sequence {1, 0, 1, ..., 1, 0} to obtain the second sequence.

8. A frame transmission apparatus, comprising:

an obtaining unit, configured to obtain an initial enhanced directional multi-gigabit header, EDMG Header, sequence, wherein the initial EDMG Header sequence comprises N control bits, and N is a positive integer;

a padding unit, configured to perform a padding operation on the initial EDMG Header sequence obtained by the obtaining unit, to obtain a padded sequence, wherein the padded sequence comprises N information bits and L padding bits, and the N information bits are the N control bits, or the N information bits are obtained by scrambling the N control bits;

an encoding unit, configured to perform 1/2 low-density parity-check, LDPC, encoding on the padded sequence obtained by the padding unit, to obtain an encoded sequence, wherein the encoded sequence comprises the N information bits, the L padding bits, and N+L parity check bits generated through encoding, and L is a positive integer;

a constructing unit, configured to: constitute a first sequence by using the N information bits and all the parity check bits in the encoded sequence obtained by the encoding unit, and obtain a second sequence based on the first sequence, wherein a length of the first sequence is the same as a length of the second sequence;

a modulation unit, configured to separately perform modulation on the first sequence and the second sequence that are obtained by the constructing unit, to obtain a first modulated sequence and a second modulated sequence; and

a processing and transmission unit, configured to: insert a guard interval, GI, between the first modulated sequence and the second modulated sequence that are obtained by the modulation unit, obtain an encoded and modulated EDMG Header sequence based on a sequence obtained after the guard interval is inserted, combine the encoded and modulated EDMG Header sequence and to-be-sent data to obtain a frame, and transmit the frame.

9. The apparatus according to claim 8, wherein a length of the encoded sequence is 672, both the length of the first sequence and the length of the second sequence are 448, and N+L=336.

10. The apparatus according to claim 8 or 9, wherein when N=112, the constructing unit is specifically configured to: perform an exclusive OR operation on the first sequence to obtain the second sequence; or perform interleaving processing on the first sequence to obtain the second sequence;

wherein the constructing unit is specifically configured to: perform the exclusive OR operation on the first sequence by using a pseudo-random sequence to obtain the second sequence; or perform the exclusive OR operation on the first sequence by using a sequence {0, 1, 0, 1, ..., 0, 1} or a sequence {1, 0, 1, ..., 1, 0} to obtain the second sequence.

11. A frame transmission apparatus, comprising:

an obtaining unit, configured to obtain an initial enhanced directional multi-gigabit header, EDMG Header, sequence, wherein the initial EDMG Header sequence comprises N control bits, and N is a positive integer;

a padding unit, configured to perform a padding operation on the initial EDMG Header sequence obtained by the obtaining unit, to obtain a padded sequence, wherein the padded sequence comprises N information bits and L padding bits, and the N information bits are the N control bits, or the N information bits are obtained by scrambling the N control bits;

an encoding unit, configured to perform 1/2 low-density parity-check, LDPC, encoding on the padded sequence obtained by the padding unit, to obtain an encoded sequence, wherein the encoded sequence comprises the N information bits, the L padding bits, and N+L parity check bits generated through encoding, and L is a positive integer;

a constructing unit, configured to: constitute a first sequence by using the N information bits and a first part of the parity check bits in the encoded sequence obtained by the encoding unit, and obtain a second sequence based on the N information bits and a second part of the parity check bits in the encoded sequence obtained by the encoding unit, wherein a length of the first sequence is the same as a length of the second sequence, and bits comprised in the first part of the parity check bits are not completely the same as those comprised in the second part of the parity check bits;

a modulation unit, configured to separately perform modulation on the first sequence and the second sequence that are obtained by the constructing unit, to obtain a first modulated sequence and a second modulated sequence; and

a processing and transmission unit, configured to: insert a guard interval, GI, between the first modulated sequence and the second modulated sequence that are obtained by the modulation unit, obtain an encoded and modulated EDMG Header sequence based on a sequence obtained after the guard interval is inserted, combine the encoded and modulated EDMG Header sequence and to-be-sent data to obtain a frame, and transmit the frame.

12. The apparatus according to claim 11, wherein a length of the encoded sequence is 672, both the length of the first sequence and the length of the second sequence are 448, and N+L=336.

13. The apparatus according to claim 11 or 12, wherein when N>112, the constructing unit is specifically configured to constitute the second sequence by using the N information bits and the second part of the parity check bits in the encoded sequence.

14. The apparatus according to claim 11 or 12, wherein when N>112, the constructing unit is specifically configured to: constitute a third sequence by using the N information bits and the second part of the parity check bits in the encoded sequence; and perform an exclusive OR operation or interleaving processing on the third sequence to obtain the second sequence.

15. The apparatus according to claim 14, wherein the constructing unit is specifically configured to: perform the exclusive OR operation on the third sequence by using a pseudo-random sequence to obtain the second sequence; or perform the exclusive OR operation on the third sequence by using a sequence {0, 1, 0, 1, ..., 0, 1} or a sequence {1, 0, 1, ..., 1, 0} to obtain the second sequence.

**Patentansprüche**

1. Rahmenübertragungsverfahren, Folgendes umfassend:

    Erhalten einer anfänglichen erweiterten direktionalen Multi-Gigabit-Header (EDMG-Header)-Sequenz, wobei die anfängliche EDMG-Header-Sequenz N Steuerbits umfasst und N eine positive Ganzzahl ist;
    Durchführen einer Padding-Operation an der anfänglichen EDMG-Header-Sequenz, um eine aufgefüllte Sequenz zu erhalten,
    wobei die aufgefüllte Sequenz N Informationsbits und L Padding-Bits umfasst und die N Informationsbits die N Steuerbits sind, oder die N Informationsbits durch Verwürfeln der N Steuerbits erhalten werden;
    Durchführen einer 1/2 Low-Density Parity-Check (LDPC)-Codierung an der aufgefüllten Sequenz, um eine codierte Sequenz zu erhalten,
    wobei die codierte Sequenz die N Informationsbits, die L Padding-Bits und durch Codierung erzeugte N+L Paritätsprüfbits umfasst und L eine positive Ganzzahl ist;
    Bilden einer ersten Sequenz durch Verwenden der N Informationsbits und aller Paritätsprüfbits in der codierten Sequenz, und Erhalten einer zweiten Sequenz auf der Basis der ersten Sequenz,
    wobei eine Länge der ersten Sequenz mit einer Länge der zweiten Sequenz identisch ist;
    Modulieren der ersten Sequenz, um eine erste modulierte Sequenz zu erhalten, und Modulieren der zweiten Sequenz, um eine zweite modulierte Sequenz zu erhalten; und
    Einfügen eines Schutzintervalls (GI) zwischen der ersten modulierten Sequenz und der zweiten modulierten Sequenz,
    Erhalten einer codierten und modulierten EDMG-Header-Sequenz auf der Basis einer nach dem Einfügen des Schutzintervalls erhaltenen Sequenz,
    Kombinieren der codierten und modulierten EDMG-Header-Sequenz und zu sendender Daten, um einen Rahmen zu erhalten, und Übertragen des Rahmens.

**2.** Verfahren gemäß Anspruch 1,
wobei eine Länge der codierten Sequenz 672 beträgt, die Länge sowohl der ersten Sequenz als auch die Länge der zweiten Sequenz 448 beträgt, und N+L=336.

**3.** Verfahren gemäß Anspruch 1 oder 2,
wobei, wenn N=112, das Erhalten einer zweiten Sequenz auf der Basis der ersten Sequenz Folgendes umfasst:

Durchführen einer exklusiven ODER-Operation an der ersten Sequenz, um die zweite Sequenz zu erhalten; oder Durchführen einer Verschachtelungsverarbeitung an der ersten Sequenz, um die zweite Sequenz zu erhalten;
wobei das Durchführen einer exklusiven ODER-Operation an der ersten Sequenz zum Erhalten der zweiten Sequenz Folgendes umfasst:
Durchführen der exklusiven ODER-Operation an der ersten Sequenz durch Verwenden einer Pseudo-Zufallssequenz, um die zweite Sequenz zu erhalten; oder Durchführen der exklusiven ODER-Operation an der ersten Sequenz durch Verwenden einer Sequenz {0, 1, 0, 1,..., 0, 1} oder einer Sequenz {1, 0, 1,..., 1, 0}, um die zweite Sequenz zu erhalten.

**4.** Rahmenübertragungsverfahren, Folgendes umfassend:

Erhalten einer anfänglichen erweiterten direktionalen Multi-Gigabit-Header (EDMG-Header)-Sequenz,
wobei die anfängliche EDMG-Header-Sequenz N Steuerbits umfasst und N eine positive Ganzzahl ist;
Durchführen einer Padding-Operation an der anfänglichen EDMG-Header-Sequenz, um eine aufgefüllte Sequenz zu erhalten,
wobei die aufgefüllte Sequenz N Informationsbits und L Padding-Bits umfasst und die N Informationsbits die N Steuerbits sind, oder die N Informationsbits erhalten werden, indem Verwürfeln an den N Steuerbits durchgeführt wird;
Durchführen einer 1/2 Low-Density Parity-Check (LDPC)-Codierung an der aufgefüllten Sequenz, um eine codierte Sequenz zu erhalten,
wobei die codierte Sequenz die N Informationsbits, die L Padding-Bits und durch Codierung erzeugte N+L Paritätsprüfbits umfasst und L eine positive Ganzzahl ist;
Bilden einer ersten Sequenz durch Verwenden der N Informationsbits und eines ersten Teils der Paritätsprüfbits in der codierten Sequenz, und
Erhalten einer zweiten Sequenz auf der Basis der N Informationsbits und eines zweiten Teils der Paritätsprüfbits in der codierten Sequenz,
wobei eine Länge der ersten Sequenz mit einer Länge der zweiten Sequenz identisch ist, und in dem ersten Teil der Paritätsprüfbits enthaltene Bits nicht vollkommen identisch mit denjenigen sind, die in dem zweiten Teil der Paritätsprüfbits enthalten sind;
Modulieren der ersten Sequenz, um eine erste modulierte Sequenz zu erhalten, und Modulieren der zweiten Sequenz, um eine zweite modulierte Sequenz zu erhalten; und
Einfügen eines Schutzintervalls (GI) zwischen der ersten modulierten Sequenz und der zweiten modulierten Sequenz,
Erhalten einer codierten und modulierten EDMG-Header-Sequenz auf der Basis einer nach dem Einfügen des Schutzintervalls erhaltenen Sequenz,
Kombinieren der codierten und modulierten EDMG-Header-Sequenz und zu sendender Daten, um einen Rahmen zu erhalten, und Übertragen des Rahmens.

**5.** Verfahren gemäß Anspruch 4,
wobei eine Länge der codierten Sequenz 672 beträgt, die Länge sowohl der ersten Sequenz als auch die Länge der zweiten Sequenz 448 beträgt, und N+L=336.

**6.** Verfahren gemäß Anspruch 4 oder 5,
wobei, wenn N>112, das Erhalten der zweiten Sequenz auf der Basis der N Informationsbits und eines zweiten Teils der Paritätsprüfbits in der codierten Sequenz Folgendes umfasst:
Bilden der zweiten Sequenz durch Verwenden der N Informationsbits und des zweiten Teils der Paritätsprüfbits in der codierten Sequenz.

**7.** Verfahren gemäß Anspruch 4 oder 5,
wobei, wenn N>112, das Erhalten der zweiten Sequenz auf der Basis der N Informationsbits und eines zweiten Teils der Paritätsprüfbits in der codierten Sequenz Folgendes umfasst:

Bilden einer dritten Sequenz durch Verwenden der N Informationsbits und des zweiten Teils der Paritätsprüfbits in der codierten Sequenz; und

Durchführen einer exklusiven ODER-Operation oder einer Verschachtelungsverarbeitung an der dritten Sequenz, um die zweite Sequenz zu erhalten;

wobei das Durchführen einer exklusiven ODER-Operation oder einer Verschachtelungsverarbeitung an der dritten Sequenz zum Erhalten der zweiten Sequenz Folgendes umfasst:

Durchführen der exklusiven ODER-Operation an der dritten Sequenz durch Verwenden einer Pseudo-Zufallssequenz, um die zweite Sequenz zu erhalten; oder Durchführen der exklusiven ODER-Operation an der dritten Sequenz durch Verwenden einer Sequenz {0, 1, 0, 1,..., 0, 1} oder einer Sequenz {1, 0, 1,..., 1, 0}, um die zweite Sequenz zu erhalten.

8. Rahmenübertragungsvorrichtung, Folgendes umfassend:

eine Erhaltungseinheit, die dazu ausgelegt ist, eine anfängliche erweiterte direktionale Multi-Gigabit-Header (EDMG-Header)-Sequenz zu erhalten,
wobei die anfängliche EDMG-Header-Sequenz N Steuerbits umfasst und N eine positive Ganzzahl ist;
eine Padding-Einheit, die dazu ausgelegt ist, eine Padding-Operation an der durch die Erhaltungseinheit erhaltenen anfänglichen EDMG-Header-Sequenz durchzuführen, um eine aufgefüllte Sequenz zu erhalten,
wobei die aufgefüllte Sequenz N Informationsbits und L Padding-Bits umfasst und die N Informationsbits die N Steuerbits sind, oder die N Informationsbits durch Verwürfeln der N Steuerbits erhalten werden;
eine Codiereinheit, die dazu ausgelegt ist, eine 1/2 Low-Density Parity-Check (LDPC)-Codierung an der durch die Padding-Einheit erhaltenen aufgefüllten Sequenz durchzuführen, um eine codierte Sequenz zu erhalten,
wobei die codierte Sequenz die N Informationsbits, die L Padding-Bits und durch Codierung erzeugte N+L Paritätsprüfbits umfasst und L eine positive Ganzzahl ist;
eine Konstruktionseinheit, die für Folgendes ausgelegt ist:

Bilden einer ersten Sequenz durch Verwenden der N Informationsbits und aller Paritätsprüfbits in der durch die Codiereinheit erhaltenen codierten Sequenz, und Erhalten einer zweiten Sequenz auf der Basis der ersten Sequenz,
wobei eine Länge der ersten Sequenz mit einer Länge der zweiten Sequenz identisch ist;
eine Modulationseinheit, die dazu ausgelegt ist, eine Modulation an der ersten Sequenz und der zweiten Sequenz getrennt durchzuführen, die durch die Konstruktionseinheit erhalten werden, um eine erste modulierte Sequenz und eine zweite modulierte Sequenz zu erhalten; und
eine Verarbeitungs- und Übertragungseinheit, die für Folgendes ausgelegt ist:

Einfügen eines Schutzintervalls (GI) zwischen der ersten modulierten Sequenz und der zweiten modulierten Sequenz, die durch die Modulationseinheit erhalten werden, Erhalten einer codierten und modulierten EDMG-Header-Sequenz auf der Basis einer nach dem Einfügen des Schutzintervalls erhaltenen Sequenz,
Kombinieren der codierten und modulierten EDMG-Header-Sequenz und zu sendender Daten, um einen Rahmen zu erhalten, und Übertragen des Rahmens.

9. Vorrichtung gemäß Anspruch 8,
wobei eine Länge der codierten Sequenz 672 beträgt, die Länge sowohl der ersten Sequenz als auch die Länge der zweiten Sequenz 448 beträgt, und N+L=336.

10. Vorrichtung gemäß Anspruch 8 oder 9,
wobei, wenn N=112, die Konstruktionseinheit speziell für Folgendes ausgelegt ist:

Durchführen einer exklusiven ODER-Operation an der ersten Sequenz, um die zweite Sequenz zu erhalten; oder Durchführen einer Verschachtelungsverarbeitung an der ersten Sequenz, um die zweite Sequenz zu erhalten;
wobei die Konstruktionseinheit speziell für Folgendes ausgelegt ist:
Durchführen der exklusiven ODER-Operation an der ersten Sequenz durch Verwenden einer Pseudo-Zufallssequenz, um die zweite Sequenz zu erhalten; oder Durchführen der exklusiven ODER-Operation an der ersten Sequenz durch Verwenden einer Sequenz {0, 1, 0, 1,..., 0, 1} oder einer Sequenz {1, 0, 1,..., 1, 0}, um die zweite Sequenz zu erhalten.

11. Rahmenübertragungsvorrichtung, Folgendes umfassend:

eine Erhaltungseinheit, die dazu ausgelegt ist, eine anfängliche erweiterte direktionale Multi-Gigabit-Header (EDMG-Header)-Sequenz zu erhalten,
wobei die anfängliche EDMG-Header-Sequenz N Steuerbits umfasst und N eine positive Ganzzahl ist;
eine Padding-Einheit, die dazu ausgelegt ist, eine Padding-Operation an der durch die Erhaltungseinheit erhaltenen anfänglichen EDMG-Header-Sequenz durchzuführen, um eine aufgefüllte Sequenz zu erhalten,
wobei die aufgefüllte Sequenz N Informationsbits und L Padding-Bits umfasst und die N Informationsbits die N Steuerbits sind, oder die N Informationsbits durch Verwürfeln der N Steuerbits erhalten werden;
eine Codiereinheit, die dazu ausgelegt ist, eine 1/2 Low-Density Parity-Check (LDPC)-Codierung an der durch die Padding-Einheit erhaltenen aufgefüllten Sequenz durchzuführen, um eine codierte Sequenz zu erhalten,
wobei die codierte Sequenz die N Informationsbits, die L Padding-Bits und durch Codierung erzeugte N+L Paritätsprüfbits umfasst und L eine positive Ganzzahl ist;
eine Konstruktionseinheit, die für Folgendes ausgelegt ist:

Bilden einer ersten Sequenz durch Verwenden der N Informationsbits und eines ersten Teils der Paritätsprüfbits in der durch die Codiereinheit erhaltenen codierten Sequenz, und
Erhalten einer zweiten Sequenz auf der Basis der N Informationsbits und eines zweiten Teils der Paritätsprüfbits in der durch die Codiereinheit erhaltenen codierten Sequenz,
wobei eine Länge der ersten Sequenz mit einer Länge der zweiten Sequenz identisch ist, und in dem ersten Teil der Paritätsprüfbits enthaltene Bits nicht vollkommen identisch mit denjenigen sind, die in dem zweiten Teil der Paritätsprüfbits enthalten sind;
eine Modulationseinheit, die dazu ausgelegt ist, eine Modulation an der ersten Sequenz und der zweiten Sequenz getrennt durchzuführen, die durch die Konstruktionseinheit erhalten werden, um eine erste modulierte Sequenz und eine zweite modulierte Sequenz zu erhalten; und
eine Verarbeitungs- und Übertragungseinheit, die für Folgendes ausgelegt ist:

Einfügen eines Schutzintervalls (GI) zwischen der ersten modulierten Sequenz und der zweiten modulierten Sequenz, die durch die Modulationseinheit erhalten werden, Erhalten einer codierten und modulierten EDMG-Header-Sequenz auf der Basis einer nach dem Einfügen des Schutzintervalls erhaltenen Sequenz,
Kombinieren der codierten und modulierten EDMG-Header-Sequenz und zu sendender Daten, um einen Rahmen zu erhalten, und Übertragen des Rahmens.

12. Vorrichtung gemäß Anspruch 11,
wobei eine Länge der codierten Sequenz 672 beträgt, die Länge sowohl der ersten Sequenz als auch die Länge der zweiten Sequenz 448 beträgt, und N+L=336.

13. Vorrichtung gemäß Anspruch 11 oder 12,
wobei, wenn N>112, die Konstruktionseinheit speziell dazu ausgelegt ist, die zweite Sequenz durch Verwenden der N Informationsbits und des zweiten Teils der Paritätsprüfbits in der codierten Sequenz zu bilden.

14. Vorrichtung gemäß Anspruch 11 oder 12,
wobei, wenn N>112, die Konstruktionseinheit speziell für Folgendes ausgelegt ist:

Bilden einer dritten Sequenz durch Verwenden der N Informationsbits und des zweiten Teils der Paritätsprüfbits in der codierten Sequenz; und
Durchführen einer exklusiven ODER-Operation oder einer Verschachtelungsverarbeitung an der dritten Sequenz, um die zweite Sequenz zu erhalten.

15. Vorrichtung gemäß Anspruch 14,
wobei die Konstruktionseinheit speziell für Folgendes ausgelegt ist:

Durchführen der exklusiven ODER-Operation an der dritten Sequenz durch Verwenden einer Pseudo-Zufallssequenz, um die zweite Sequenz zu erhalten; oder
Durchführen der exklusiven ODER-Operation an der dritten Sequenz durch Verwenden einer Sequenz {0, 1, 0, 1,..., 0, 1} oder einer Sequenz {1, 0, 1,..., 1, 0}, um die zweite Sequenz zu erhalten.

**Revendications**

1. Procédé de transmission de trames, comprenant les étapes consistant à :

obtenir une séquence initiale d'en-têtes multi-gigabits directionnels améliorés (en-tête EDMG), la séquence initiale d'en-têtes EDMG comprenant N bits de contrôle, N étant un entier positif ;

réaliser une opération de remplissage sur la séquence initiale d'en-têtes EDMG afin d'obtenir une séquence remplie, la séquence remplie comprenant N bits d'information et L bits de remplissage, les N bits d'information étant les N bits de contrôle ou les N bits d'information étant obtenus en embrouillant les N bits de contrôle ;

réaliser un 1/2 codage par contrôle de parité à faible densité (LDPC) sur la séquence remplie afin d'obtenir une séquence codée, la séquence codée comprenant les N bits d'information, les L bits de remplissage et N+L bits de contrôle de parité générés par codage, L étant un entier positif ;

constituer une première séquence au moyen des N bits d'information et de tous les bits de contrôle de parité dans la séquence codée et obtenir une deuxième séquence sur la base de la première séquence, une longueur de la première séquence étant la même qu'une longueur de la deuxième séquence ;

moduler la première séquence afin d'obtenir une première séquence modulée et moduler la deuxième séquence afin d'obtenir une deuxième séquence modulée ; et

insérer un intervalle de garde (GI) entre la première séquence modulée et la deuxième séquence modulée, obtenir une séquence d'en-têtes EDMG codée et modulée sur la base d'une séquence obtenue après l'insertion de l'intervalle de garde, combiner la séquence d'en-têtes EDMG codée et modulée et des données à envoyer afin d'obtenir une trame et transmettre la trame.

2. Procédé selon la revendication 1, dans lequel une longueur de la séquence codée est 672, la longueur de la première séquence et la longueur de la deuxième séquence sont l'une et l'autre 448, et N+L=336.

3. Procédé selon la revendication 1 ou 2, dans lequel, quand N=112, l'obtention d'une deuxième séquence sur la base de la première séquence comprend l'étape consistant à :

réaliser une opération OU exclusif sur la première séquence afin d'obtenir la deuxième séquence ; ou

réaliser un traitement d'entrelacement sur la première séquence afin d'obtenir la deuxième séquence ;

la réalisation d'une opération OU exclusif sur la première séquence afin d'obtenir la deuxième séquence comprenant l'étape consistant à :

réaliser l'opération OU exclusif sur la première séquence au moyen d'une séquence pseudo-aléatoire afin d'obtenir la deuxième séquence ; ou

réaliser l'opération OU exclusif sur la première séquence au moyen d'une séquence {0, 1, 0, 1, ..., 0, 1} ou d'une séquence {1, 0, 1, ..., 1, 0} afin d'obtenir la deuxième séquence.

4. Procédé de transmission de trames, comprenant les étapes consistant à :

obtenir une séquence initiale d'en-têtes multi-gigabits directionnels améliorés (en-tête EDMG), la séquence initiale d'en-têtes EDMG comprenant N bits de contrôle, N étant un entier positif ;

réaliser une opération de remplissage sur la séquence initiale d'en-têtes EDMG afin d'obtenir une séquence remplie, la séquence remplie comprenant N bits d'information et L bits de remplissage, les N bits d'information étant les N bits de contrôle ou les N bits d'information étant obtenus en embrouillant les N bits de contrôle ;

réaliser un 1/2 codage par contrôle de parité à faible densité (LDPC) sur la séquence remplie afin d'obtenir une séquence codée, la séquence codée comprenant les N bits d'information, les L bits de remplissage et N+L bits de contrôle de parité générés par codage, L étant un entier positif ;

constituer une première séquence au moyen des N bits d'information et d'une première partie des bits de contrôle de parité dans la séquence codée et obtenir une deuxième séquence basée sur les N bits d'information et une seconde partie des bits de contrôle de parité dans la séquence codée, une longueur de la première séquence étant la même qu'une longueur de la deuxième séquence et les bits compris dans la première partie des bits de contrôle de parité n'étant pas complètement les mêmes que ceux compris dans la seconde partie des bits de contrôle de parité ;

moduler la première séquence afin d'obtenir une première séquence modulée et moduler la deuxième séquence afin d'obtenir une deuxième séquence modulée ; et

insérer un intervalle de garde (GI) entre la première séquence modulée et la deuxième séquence modulée, obtenir une séquence d'en-têtes EDMG codée et modulée sur la base d'une séquence obtenue après l'insertion de l'intervalle de garde, combiner la séquence d'en-têtes EDMG codée et modulée et des données à envoyer afin d'obtenir une trame et transmettre la trame.

5. Procédé selon la revendication 4, dans lequel une longueur de la séquence codée est 672, la longueur de la première séquence et la longueur de la deuxième séquence sont l'une et l'autre 448, et N+L=336.

6. Procédé selon la revendication 4 ou 5, dans lequel, quand N>112, l'obtention de la deuxième séquence sur la base des N bits d'information et d'une seconde partie des bits de contrôle de parité dans la séquence codée comprend l'étape consistant à :
constituer la deuxième séquence au moyen des N bits d'information et de la seconde partie des bits de contrôle de parité dans la séquence codée.

7. Procédé selon la revendication 4 ou 5, dans lequel, quand N>112, l'obtention de la deuxième séquence sur la base des N bits d'information et d'une seconde partie des bits de contrôle de parité dans la séquence codée comprend les étapes consistant à :

constituer une troisième séquence au moyen des N bits d'information et de la seconde partie des bits de contrôle de parité dans la séquence codée ; et
réaliser une opération OU exclusif ou un traitement d'entrelacement sur la troisième séquence afin d'obtenir la deuxième séquence ;
la réalisation d'une opération OU exclusif ou d'un traitement d'entrelacement sur la troisième séquence afin d'obtenir la deuxième séquence comprenant l'étape consistant à :

réaliser l'opération OU exclusif sur la troisième séquence au moyen d'une séquence pseudo-aléatoire afin d'obtenir la deuxième séquence ; ou
réaliser l'opération OU exclusif sur la troisième séquence au moyen d'une séquence {0, 1, 0, 1, ..., 0, 1} ou d'une séquence {1, 0, 1, ..., 1, 0} afin d'obtenir la deuxième séquence.

8. Appareil de transmission de trames, comprenant :

une unité d'obtention, configurée pour obtenir une séquence initiale d'en-têtes multi-gigabits directionnels améliorés (en-tête EDMG), la séquence initiale d'en-têtes EDMG comprenant N bits de contrôle, N étant un entier positif ;
une unité de remplissage, configurée pour réaliser une opération de remplissage sur la séquence initiale d'en-têtes EDMG obtenue par l'unité d'obtention, afin d'obtenir une séquence remplie, la séquence remplie comprenant N bits d'information et L bits de remplissage, les N bits d'information étant les N bits de contrôle ou les N bits d'information étant obtenus en embrouillant les N bits de contrôle ;
une unité de codage, configurée pour réaliser un 1/2 codage par contrôle de parité à faible densité (LDPC) sur la séquence remplie obtenue par l'unité de remplissage, afin d'obtenir une séquence codée, la séquence codée comprenant les N bits d'information, les L bits de remplissage et N+L bits de contrôle de parité générés par codage, L étant un entier positif ;
une unité de construction, configurée pour : constituer une première séquence au moyen des N bits d'information et de tous les bits de contrôle de parité dans la séquence codée obtenue par l'unité de codage et obtenir une deuxième séquence sur la base de la première séquence, une longueur de la première séquence étant la même qu'une longueur de la deuxième séquence ;
une unité de modulation, configurée pour réaliser séparément une modulation sur la première séquence et la deuxième séquence qui sont obtenues par l'unité de construction, afin d'obtenir une première séquence modulée et une deuxième séquence modulée ; et
une unité de traitement et de transmission, configurée pour : insérer un intervalle de garde (GI) entre la première séquence modulée et la deuxième séquence modulée qui sont obtenues par l'unité de modulation, obtenir une séquence d'en-têtes EDMG codée et modulée sur la base d'une séquence obtenue après l'insertion de l'intervalle de garde, combiner la séquence d'en-têtes EDMG codée et modulée et des données à envoyer afin d'obtenir une trame et transmettre la trame.

9. Appareil selon la revendication 8, dans lequel une longueur de la séquence codée est 672, la longueur de la première séquence et la longueur de la deuxième séquence sont l'une et l'autre 448, et N+L=336.

10. Appareil selon la revendication 8 ou 9, dans lequel, quand N=112, l'unité de construction est spécifiquement configurée pour : réaliser une opération OU exclusif sur la première séquence afin d'obtenir la deuxième séquence ; ou réaliser un traitement d'entrelacement sur la première séquence afin d'obtenir la deuxième séquence ; l'unité de construction étant spécifiquement configurée pour : réaliser l'opération OU exclusif sur la première séquence au moyen d'une séquence pseudo-aléatoire afin d'obtenir la deuxième séquence ; ou réaliser l'opération OU exclusif sur la première séquence au moyen d'une séquence {0, 1, 0, 1, ..., 0, 1} ou d'une séquence {1, 0, 1, ..., 1, 0} afin d'obtenir la deuxième séquence.

11. Appareil de transmission de trames, comprenant :

une unité d'obtention, configurée pour obtenir une séquence initiale d'en-têtes multi-gigabits directionnels améliorés (en-tête EDMG), la séquence initiale d'en-têtes EDMG comprenant N bits de contrôle, N étant un entier positif ;
une unité de remplissage, configurée pour réaliser une opération de remplissage sur la séquence initiale d'en-têtes EDMG obtenue par l'unité d'obtention, afin d'obtenir une séquence remplie, la séquence remplie comprenant N bits d'information et L bits de remplissage, les N bits d'information étant les N bits de contrôle ou les N bits d'information étant obtenus en embrouillant les N bits de contrôle ;
une unité de codage, configurée pour réaliser un 1/2 codage par contrôle de parité à faible densité (LDPC) sur la séquence remplie obtenue par l'unité de remplissage, afin d'obtenir une séquence codée, la séquence codée comprenant les N bits d'information, les L bits de remplissage et N+L bits de contrôle de parité générés par codage, L étant un entier positif ;
une unité de construction, configurée pour : constituer une première séquence au moyen des N bits d'information et d'une première partie des bits de contrôle de parité dans la séquence codée obtenue par l'unité de codage et obtenir une deuxième séquence basée sur les N bits d'information et une seconde partie des bits de contrôle de parité dans la séquence codée obtenue par l'unité de codage, une longueur de la première séquence étant la même qu'une longueur de la deuxième séquence et les bits compris dans la première partie des bits de contrôle de parité n'étant pas complètement les mêmes que ceux compris dans la seconde partie des bits de contrôle de parité ;
une unité de modulation, configurée pour réaliser séparément une modulation sur la première séquence et la deuxième séquence qui sont obtenues par l'unité de construction, afin d'obtenir une première séquence modulée et une deuxième séquence modulée ; et
une unité de traitement et de transmission, configurée pour : insérer un intervalle de garde (GI) entre la première séquence modulée et la deuxième séquence modulée qui sont obtenues par l'unité de modulation, obtenir une séquence d'en-têtes EDMG codée et modulée sur la base d'une séquence obtenue après l'insertion de l'intervalle de garde, combiner la séquence d'en-têtes EDMG codée et modulée et des données à envoyer afin d'obtenir une trame et transmettre la trame.

12. Appareil selon la revendication 11, dans lequel une longueur de la séquence codée est 672, la longueur de la première séquence et la longueur de la deuxième séquence sont l'une et l'autre 448, et N+L=336.

13. Appareil selon la revendication 11 ou 12, dans lequel, quand N>112, l'unité de construction est spécifiquement configurée pour constituer la deuxième séquence au moyen des N bits d'information et de la seconde partie des bits de contrôle de parité dans la séquence codée.

14. Appareil selon la revendication 11 ou 12, dans lequel, quand N>112, l'unité de construction est spécifiquement configurée pour : obtenir une troisième séquence au moyen des N bits d'information et de la seconde partie des bits de contrôle de parité dans la séquence codée ; et réaliser une opération OU exclusif ou un traitement d'entrelacement sur la troisième séquence afin d'obtenir la deuxième séquence.

15. Appareil selon la revendication 14, dans lequel l'unité de construction est spécifiquement configurée pour : réaliser l'opération OU exclusif sur la troisième séquence au moyen d'une séquence pseudo-aléatoire afin d'obtenir la deuxième séquence ; ou réaliser l'opération OU exclusif sur la troisième séquence au moyen d'une séquence {0, 1, 0, 1, ..., 0, 1} ou d'une séquence {1, 0, 1, ..., 1, 0} afin d'obtenir la deuxième séquence.

FIG. 1

Obtain an initial EDMG Header sequence, where the initial EDMG Header sequence includes N control bits, and N is a positive integer ⌐⌐ 101

↓

Perform a padding operation on the initial EDMG Header sequence to obtain a padded sequence, where the padded sequence includes N information bits and L padding bits, and the N information bits are the N control bits, or the N information bits are obtained by scrambling the N control bits ⌐⌐ 102

↓

Perform 1/2 LDPC encoding on the padded sequence to obtain an encoded sequence, where the encoded sequence includes the N information bits, the L padding bits, and N+L parity check bits generated through encoding, and L is a positive integer ⌐⌐ 103

↓

Constitute a first sequence by using the N information bits and all the parity check bits in the encoded sequence, and obtain a second sequence based on the first sequence, where a length of the first sequence is the same as a length of the second sequence ⌐⌐ 104

↓

Modulate the first sequence to obtain a first modulated sequence, and modulate the second sequence to obtain a second modulated sequence ⌐⌐ 105

↓

Insert a guard interval GI between the first modulated sequence and the second modulated sequence, obtain an encoded and modulated EDMG Header sequence based on a sequence obtained after the guard interval is inserted, combine the encoded and modulated EDMG Header sequence and to-be-sent data to obtain a frame, and transmit the frame ⌐⌐ 106

FIG. 2

Obtain an initial EDMG Header sequence, where the initial EDMG Header sequence includes N control bits, and N is a positive integer

201

Perform a padding operation on the initial EDMG Header sequence to obtain a padded sequence, where the padded sequence includes N information bits and L padding bits, and the N information bits are the N control bits, or the N information bits are obtained by scrambling the N control bits

202

Perform 1/2 LDPC encoding on the pdded sequence to obtain an encoded sequence, where the encoded sequence includes the N information bits, the L padding bits, and N+L parity check bits generated through encoding, and L is a positive integer

203

Constitute a first sequence by using the N information bits and a first part of the parity check bits in the encoded sequence, and obtain a second sequence based on the N information bits and a second part of the parity check bits in the encoded sequence, where a length of the first sequence is the same as a length of the second sequence, and bits included in the first part of the parity check bits are not completely the same as those included in the second part of the parity check bits

204

Modulate the first sequence to obtain a first modulated sequence, and modulate the second sequence to obtain a second modulated sequence

205

Insert a guard interval GI between the first modulated sequence and the second modulated sequence, obtain an encoded and modulated EDMG Header sequence based on a sequence obtained after the guard interval is inserted, combine the encoded and modulated EDMG Header sequence and to-be-sent data to obtain a frame, and transmit the frame

206

FIG. 3

| STF | CE | Header | EDMG-Header | EDMG Payload |
|-----|-----|--------|-------------|--------------|

FIG. 4

| GI | First modulation sequence | GI | Second modulation sequence | GI |
|-----|---------------------------|-----|----------------------------|-----|

FIG. 5

```
┌─────────────────────────┬─────────────┐
│   EDMG-Header (96)       │  CRC (16)   │
└─────────────────────────┴─────────────┘
             │
             │  201. Fill a bit
             ▼
┌─────────────────┬─────────────┬──────────────────┐
│ EDMG-Header (96)│  CRC (16)   │ Padding 0 bits   │
│                 │             │      (224)       │
└─────────────────┴─────────────┴──────────────────┘
             │
             │  202. 1/2 LDPC
             │       encoding
             ▼
┌─────────────────┬─────────────┬────────────────┬──────────────────────┐
│ EDMG-Header (96)│  CRC (16)   │ Padding 0 bits │ Parity check bits (336)│
│                 │             │     (224)      │                        │
└─────────────────┴─────────────┴────────────────┴──────────────────────┘
             │
             │  203. Remove 0 bits
             ▼
┌─────────────────┬─────────────┬──────────────────────────┐
│ EDMG-Header (96)│  CRC (16)   │ Parity check bits (336)  │
└─────────────────┴─────────────┴──────────────────────────┘
```

205. Exclusive OR operation
or interleaving processing

┌─────────────┐
│   Second    │
│  sequence   │
└─────────────┘

204. Modulation
and mapping

207. Insert a
guard interval

207. Insert a
guard interval

206. Modulation
and mapping

207. Insert a
guard interval

```
┌──────┬──────────────────┬──────┬──────────────────┬──────┐
│  GI  │ First modulated  │  GI  │ Second modulated │  GI  │
│      │    sequence      │      │     sequence     │      │
└──────┴──────────────────┴──────┴──────────────────┴──────┘
```

FIG. 6

FIG. 7

FIG. 8

FIG. 9

FIG. 10

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160164800 A1
- EP 2320574 A2